# EUROPEAN PATENT SPECIFICATION

(11) **EP 1 535 240 B1**
(45) Date of publication and mention of the grant of the patent: **11.03.2009**
(21) Application number: 03792830.6
(22) Date of filing: 25.08.2003
(51) Int. Cl.: G06K 19/077

(54) **SIM, IC MODULE AND IC CARD**
SIM, IC-MODUL UND IC-KARTE
MODULE D'IDENTITE D'ABONNE (SIM), MODULE A CIRCUIT INTEGRE ET CARTE A CIRCUIT INTEGRE

(30) Priority: 26.08.2002 JP 2002244613; 30.09.2002 JP 2002284825; 15.10.2002 JP 2002300072; 16.10.2002 JP 2002301299; 07.05.2003 JP 2003128642
(43) Date of publication of application: 01.06.2005
(73) Proprietor: DAI NIPPON PRINTING CO., LTD., Tokyo 162-8001 (JP)
(72) Inventor: Nishikawa, Seiichi, Dai Nippon Printing Co., Ltd., Tokyo 162-8001 (JP)
(74) Representative: Müller-Boré & Partner Patentanwälte
(86) International application number: PCT/JP2003/010703
(87) International publication number: WO 2004/019261

(56) References cited:
- EP-A- 0 409 241
- WO-A-02/31762
- DE-A- 19 500 925
- FR-A- 2 769 390
- GB-A- 2 309 108
- US-A- 5 598 032
- US-A- 6 142 381
- HAGHIRI Y., TARANTINO T.: "Vom Plastik zur Chipkarte, Wegweiser zum Aufbau und zur Herstellung von Chipkarten" 1999, CARL HANSER VERLAG , MÜNCHEN, WIEN , XP002267750 page 8 - page 10
- PATENT ABSTRACTS OF JAPAN vol. 2002, no. 12, 12 December 2002 (2002-12-12) -& JP 2002 236901 A (DAINIPPON PRINTING CO LTD), 23 August 2002 (2002-08-23)

## Description

### TECHNICAL FIELD

The present invention relates to a SIM, an IC module, and an IC card. More specifically, the present invention relates to a SIM (ID module) provided with a noncontact IC chip, an IC module, and an IC card.

### BACKGROUND ART

A key holder type ID module that can be carried together with a door key for a car has been used in recent years. This ID module is provided with a built-in noncontact IC chip and a built-in antenna, and is fabricated by injection molding or the like.

As' mentioned in, for example, the Nikkei Sangyo Shinbun, Front page, Aug. 7, 2002, a charge for gasoline bought at a self-service gas station can instantly be paid in a noncontact mode through noncontact communication between such a key holder and the filling pump when such the key holder is held opposite to an automatic accounting system.

Payment is made later by a credit card, which saves the user from the trouble of inserting the credit card in an accounting machine.

Attachments for noncontact communication using IC cards are disclosed in JP10-334193A (Reference 1) and Jpn. Utility Model No. 2550502 (Reference 2). Reference 1 uses a remote control device using an infrared beam or a laser beam for noncontact communication with a wallet-size card. This remote control device is provided with an optical transmission device, a battery and such and hence inevitably large. Reference 2 uses an IC card not provided with any noncontact communication interface, and noncontact communication between the IC card and an external device is achieved indirectly through an attachment. Such an attachment is large and cannot be formed in a small size.

The key holder type ID module mentioned above is provided with an IC chip and is fabricated by molding a resin by injection molding or the like. Therefore the key holder type ID module cannot be fabricated and issued by the same procedures as conventional IC cards.

A small SIM or a UIM or a security ID module called a USIM card is incorporated into recent portable telephones (cellular phones). In Japan also, the latest portable telephones provided with a USIM card have practically been used.

A UIM (User Identity Module) is a small IC card issued by a portable telephone company and holding user information. The UIM is incorporated into a portable telephone for identifying the user.

the UIM developed through the feature expansion of a SIM (Subscriber Identity Module) is capable of holding in addition to the user information, encrypted private information including a telephone directory and personal identification information for the settlement of credit account.

Since the UIM is based on the SIM, similar in function to the SIM, the UIM is called sometimes a USIM (Universal SIM). Whereas the SIM is intended for use in using GSM portable telephone service, the UIM is intended for use to receive international roaming service by inserting the same in a cdma 2000 portable telephone of America.

In all cases, the SIM and the UIM can easily be fabricated and issued by existing techniques.

Document US 5,598,032 discloses a contact-free card and a method for the manufacture of such a card. The card comprises a card body, an electronic module having an integrated chip card and two contact zones, and an antenna connected to the contact zones of said module by two contact terminals, wherein said module furthermore has contact pads connected to said chip for a contact-using operation of said card.

DE 195 00 925 discloses a method for producing an IC card for noncontact communication. The IC card consists of a card, a transmission module (an antenna coil or dielectric sheets) and contact terminals for contact to an IC module.

Document FR 2 769 390 A1 discloses a method for making smart cards capable of operating with and without contact called mixed cards and contactless smart cards.

Document JP 2002-236901 discloses an electronic information record medium which is so constructed that a terminal for connecting an external terminal and a terminal for connecting an external antenna are formed on the surface of a thin board, and the terminal for connecting the external terminal and the terminal for connecting the external antenna are electrically connected to an integrated circuit chip jointly having a contact communication function and a contactless communication function.

### DISCLOSURE OF THE INVENTION

Accordingly, it is an object of the present invention to provide a SIM, an IC module and an IC card that can be used as a noncontact ID module by forming a noncontact ID unit in the shape of a SIM used in a portable telephone, providing a SIM with a dual interface for both contact and noncontact communication, and providing the SIM or a holder for holding the SIM with an antenna.

According to the present invention there is provided an IC module, comprising a substrate; an IC chip mounted on the substrate; and a contact-terminal plate having a plurality of contact terminals; and said IC chip and said contact terminal plate are mounted on the substrate. The plurality of contact terminals includes terminals C1 - C8 conforming to ISO 7816 standard and said terminals C1 - C8 are referred to C1 - C8 in the ISO 7816 standard. The IC module includes extra contact terminals CE1, CE2 connected to antenna terminals of the IC chip, wherein said extra contact terminals CE1, CE2 of the contact terminal plate are adapted to be connected to antenna terminals of an antenna coil. A pair of U-shaped circuits are formed so as to surround the IC chip on a surface of the substrate opposite a surface of the substrate (204a) on which the contact terminal plate is mounted, the extra contact terminals CE1 and CE2 are connected to the U-shaped circuits, respectively, and the U-shaped circuits are connected to the antenna terminals of the IC chip, respectively.

Furthermore, according to the present invention there is provided an IC card comprising an IC module according to an embodiment of the present invention and a card holding the IC module.

In addition, according to the present invention there is provided a SIM, constituted of an IC card according to an embodiment of the present invention.

According to an aspect of the present invention, a SIM comprises: a substrate; an IC chip mounted on the substrate; a contact-terminal plate provided with a plurality of contact terminals; and a SIM base holding the substrate, the IC chip and the contact-terminal plate; wherein the contact terminals of the contact-terminal plate include extra contact terminals to be connected to antenna terminals formed in the IC chip.

In the SIM according to the present invention, the IC chip may include a contact interface conforming to ISO 7816-2 and ISO 7816-3, a noncontact interface conforming to ISO 14443 and a USB contact interface, the SIM base may be provibed with a SIM antenna coil, and an antenna-terminal plate to be connected to the SIM antenna coil may be formed on a surface of the substrate opposite a surface on which the contact-terminal plate is mounted.

In the SIM according to the present invention, the extra contact terminals may be a terminal CE1 disposed between terminals C1 and C5 among eight contact terminals C1 to C8, and a terminal CE2 disposed between the terminals C4 and C8.

In the SIM according to the present invention, the antenna terminals of the IC chip may be connected to the terminals CE1 and CE2 by wire bonding.

In the SIM according to the present invention, the antenna terminals of the IC chip may be connected to the terminals CE1 and CE2 via through holes.

In the SIM according to the present invention, the terminals CE1 and CE2 may be those to be connected to an antenna coil formed in a SIM holder.

In the SIM according to the present invention, a pair of U-shaped circuits are formed so as to surround the IC chip on a surface of the substrate opposite a surface of the substrate on which the contact-terminal plate is mounted, the terminals CE1 and CE2 are connected to the U-shaped circuits, respectively, and the U-shaped circuits are connected to the antenna terminals of the IC chip, respectively.

In the SIM according to the present invention, the SIM may have the shape of a thin plate having a thickness of 1.0 mm or below and a substantially rectangular shape not greater than 25 mm × 15 mm in a projection on a horizontal plane.

In the SIM according to the present invention, one or some of a half-length photograph, a name and a number may be printed on a surface of the SIM base opposite a surface of the SIM base on which the contact-terminal plate is mounted.

A SIM holder for detachably holding a SIM comprises: a case; a terminal plate contained in the case and capable of being electrically connected to a contact-terminal plate included in the SIM; and an antenna coil formed in the case; wherein terminals to be connected to the antenna coil among those formed on the terminal plate are those to be connected to contact terminals, not used for contact communication, of the SIM.

The antenna coil may be formed on an inner surface of the case so as to extend along the peripheral edges of the SIM held in the case.

The antenna coil may be formed in the case so as to surround the terminal plate along the peripheral edges of the SIM held in the case.

A part of the case may be formed of a transparent resin through which one or some of a half-length photograph, a name and a number printed on a surface of the SIM held in the case can be viewed.

The case may have a thickness of 1.0 mm or below and a rectangular shape not greater than 25 mm x 15 mm in a projection on a horizontal plane.

The SIM holder may further comprise: a converter IC chip placed in the case and capable of converting an ISO 7816 interface into a USB interface; and a USB connector placed on the case; wherein the SIM held in the case is connected to the antenna coil for noncontact communication with an external device, the converter IC chip connected to the SIM converts the ISO 7816 interface into the USB interface to enable communication with the external device through the USB interface when the SIM holder is connected through the USB connector to the external device.

The SIM held in the case may include an IC chip provided with a dual interface for contact and noncontact communication, and a SIM antenna coil connected to the IC chip.

The antenna coil may be formed on an inner surface of the case so as to extend along the peripheral edges of the SIM held in the case.

The antenna coil may be formed in the case around the terminal plate along the peripheral edges of the SIM held in the case.

A part of the case may be formed of a transparent resin through which one or some on a half-length photograph, a name and a number printed on a surface of the SIM held in the case can be viewed.

Another SIM holder for detachably holding a SIM comprises: a case; a terminal plate contained in the case and capable of being electrically connected to a contact-terminal plate included in the SIM; and an antenna coil formed in the case; wherein terminals of the terminal plate connected to the antenna coil, are connected to extra contact terminals on the SIM.

In the above SIM holder, the SIM held in the SIM holder is provided with an IC chip provided with contact, noncontact and USB contact interfaces, and a SIM antenna coil connected to the IC chip.

In the above SIM holder, the antenna coil is formed on an inner surface of the case along the peripheral edges of the SIM held in the case.

In the above SIM holder, the antenna coil is formed in the case around the terminal plate substantially along the peripheral edges of the SIM held in the case.

In the above SIM holder, at least a part of the case is formed of a transparent resin, through which one or some of a half-length photograph, a name and a number printed on a surface of the SIM held in the case can be viewed.

In the above SIM holder, terminals CEH1 and CEH2 on the terminal plate corresponding to terminals CE1 and CE2 of the SIM are connected to the antenna coils.

According to another aspect of the present invention, an IC module comprises: a substrate; an IC chip mounted on the substrate; and a contact-terminal plate having a plurality of contact terminals and mounted on the substrate; wherein the plurality of contact terminals of the contact-terminal plate include extra contact terminals connected to antenna terminals of the IC chip.

In the IC module according to the present invention, the IC chip may have a contact interface conforming to ISO 7816-2 and ISO 7816-3, a noncontact interface conforming to ISO 14443 and a USB contact interface.

In the IC module according to the present invention, the extra contact terminals may be a terminal CE1 disposed between terminals C1 and C5 among eight contact terminals C1 to C8, and a terminal CE2 disposed between the terminals C4 and C8.

In the IC module according to the present invention, the antenna terminals of the IC chip may be connected to the terminals CE1 and CE2 by wire bonding.

In the IC module according to the present invention, the antenna terminals of the IC chip may be connected to the terminals CE1 and CE2 via through holes.

In the IC module according to the present invention, the terminals CE1 and CE2 may be those to be connected to an antenna coil formed in a SIM holder.

In the IC module according to the present invention, a pair of U-shaped circuits are formed so as to surround The IC chip on a surface of the substrate opposite a surface of the substrate on which the contact-terminal plate is mounted, the terminals CE1 and CE2 are connected to the U-shaped circuits, respectively, and the U-shaped circuits are connected to the antenna terminals of the IC chip, respectively.

In the IC module according to the present invention, the U-shaped circuits may be connected to antenna terminals of the IC chip by wire bonding.

In the IC module according to the present invention, the U-shaped circuits may be connected to extra contact terminals included in the plurality of contact terminals.

In the IC module according to the present invention, the U-shaped circuits may be connected to the extra contact terminals via through holes, respectively.

In the IC module according to the present invention, the extra contact terminals may be connected to an antenna coil formed on a SIM holder or an IC card holder.

According to another aspect of the present invention, an IC card comprises: a substrate; an IC chip mounted on the substrate; a contact-terminal plate provided with a plurality of contact terminals and mounted on the substrate; and a card holding the substrate, the IC chip and the contact-terminal plate; wherein the plurality of contact terminals of the contact-terminal plate include extra contact terminals connected to antenna terminals of the IC chip.

In the IC card according to the present invention, the IC chip includes a contact interface conforming to ISO 7816-2 and ISO 7816-3, and preferably a noncontact interface conforming to ISO 14443 and a USB contact interface, the card is provided with an antenna coil, and an antenna-terminal plate to be connected with the antenna coil is attached to a surface of the substrate opposite a surface on which the contact-terminal plate is mounted.

In the IC card according to the present invention, the extra contact terminals may be a terminal CE1 disposed between terminals C1 and C5 among eight contact terminals C1 to C8, and a terminal CE2 disposed between the terminals C4 and C8.

In the IC card according to the present invention, the antenna terminals of the IC chip may be connected to the terminals CE1 and CE2 by wire bonding.

In the IC card according to the present invention, the antenna terminals of the IC chip may be connected to the terminals CE1 and CE2 via through holes.

In the IC card according to the present invention, the terminals CE1 and CE2 may be connected to an antenna coil formed in an IC card holder.

In the IC card according to the present invention, a pair of U-shaped circuits are formed so as to surround the IC chip on a surface of the substrate opposite a surface of the substrate on which the contact-terminal plate is mounted, the terminals CE1 and CE2 are connected to the U-shaped circuits, respectively, and the U-shaped circuits are connected to the antenna terminals of the IC chip, respectively.

An IC card holder for detachably holding an IC card comprises: a case; a terminal plate contained in the case and capable of being electrically connected to a contact-terminal plate included in the IC card; and an antenna coil formed in the case; wherein terminals of the terminal plate connected to the antenna coil are connected to extra contact terminals formed on the IC card.

In the IC card holder, the IC card may have an IC chip provided with contact, noncontact and USB contact interfaces, and an antenna coil connected to the IC chip.

### BRIEF DESCRIPTION OF THE DRAWINGS

Fig. 1 is a view of a SIM in Example 1-1 of a first example not covered by the claims;
Fig. 2 is a view of a SIM in Example 1-2 of the first example not covered by the claims;
Fig. 3 is a view of a back surface of a SIM;
Fig. 4 is a view of a contact-terminal plate included in the SIM in Example 1-1;
Fig. 5 is a view of a contact-terminal plate included in the SIM in Example 1-2;
Fig. 6 is a sectional view in a plane including bonding wires of an IC module included in the SIM in Example 1-1;
Fig. 7 is a view of the IC module shown in Fig. 6 as incorporated into a SIM;
Fig. 8 is a front perspective view of assistance in explaining the use of a SIM holder;
Fig. 9 is a top plan view of a SIM holder;
Fig. 10 is a back perspective view of assistance in explaining the use of a SIM holder;
Fig. 11 is a bottom plan view of a SIM holder;
Fig. 12 is a view of a SIM in a second example not covered by the claims;
Fig. 13 is a view of an IC module in Example 2-1 employed in the SIM in the second embodiment.
Fig 14 is an IC module in Example 2-2;
Fig. 15 is a block diagram of a SIM holder according to the present invention;
Fig. 16 is a block diagram of a SIM holder in an embodiment according to the present invention;
Fig. 17 is a perspective view of a SIM holder;
Fig. 18 is a front perspective view of a SIM and a SIM holder;
Fig. 19 is a top plan view of a SIM holder holding a SIM;
Fig. 20 is a back perspective view of a SIM and a SIM holder;
Fig. 21 is a bottom plan view of a SIM holder holding a SIM;
Fig. 22 is view of assistance in explaining an IC chip to be included in an IC module in a first embodiment according to the present invention;
Fig. 23 is a view of assistance in explaining the relation between the terminals (pads) of an IC chip and a contact-terminal plate;
Fig. 24 is a view of an IC module in Example 3-1 not covered by the claims;
Fig. 25 is a view of an IC module in Example 3-2 not covered by the claims;
Fig. 26 is a view of an IC module in Example 3-3;
Fig. 27 is a view of an IC module in Example 3-4;
Fig. 28 is a view of an IC module in Example 3-5;
Fig. 29 is a view of a three-way IC card embodying the present invention;
Fig. 30 is a view of a three-way SIM embodying the present invention;
Fig. 31 is a font perspective view of a SIM and a SIM holder;
Fig. 32 is a top plan view of a SIM holder holding a SIM;
Fig. 33 is bottom plan view of a SIM and a SIM holder;
Fig. 34 is a bottom plan view of a SIM holder holding a SIM;
Fig. 35 is a front perspective view of a SIM holder and a SIM;
Fig. 36 is a top plan view of a SIM holder holding a SIM;
Fig. 37 is a bottom plan view of a SIM holder and a SIM;
Fig. 38 is a bottom plan view of a SIM holder holding a SIM;
Fig. 39 is a perspective view of assistance in explaining the wiring relation between a terminal plate and a USB connector;
Fig. 40 is a plan view of assistance in explaining the wiring relation between a SIM and the USB connector;
Fig. 41 is a perspective view of a SIM holder;
Fig. 42 is a perspective view of an IC card holder;
Fig. 43 is a sectional view of an IC module;
Fig. 44 is a sectional view of a dual interface IC module mounted on an IC card;
Fig. 45 is a plan view of an IC card provided with a dual interface IC module, and a SIM;
Fig. 46 is a view of an IC module in Example 4-1 not covered by the claims;
Fig. 47 is a view of an IC module in Example 4-2 not covered by the claims ;
Fig. 48 is a view of an IC module provided with an IC chip mounted on a substrate and having antenna pads formed near the lower side thereof;
Fig. 49 is a view of an IC module provided with an IC chip mounted on a substrate and having antenna pads formed near the upper side thereof;
Fig. 50 is a view of an IC module provided with an IC chip mounted on a substrate and having antenna pads formed on the upper and the lower side, respectively;
Fig. 51 is a view of an IC module provided with an IC chip mounted on a substrate and having antenna pads formed at middle parts of the right and left sides thereof;
Fig. 52 is a view of an IC module in Example 4-3 of a second embodiment;
Fig. 53 is a view of the IC module in Example 4-3 provided with an IC chip;
Fig. 54 is a view of the IC module in Example 4-3 provided with an IC chip;
Fig. 55 is a plan view of an IC card provided with three types of interfaces, and a SIM;

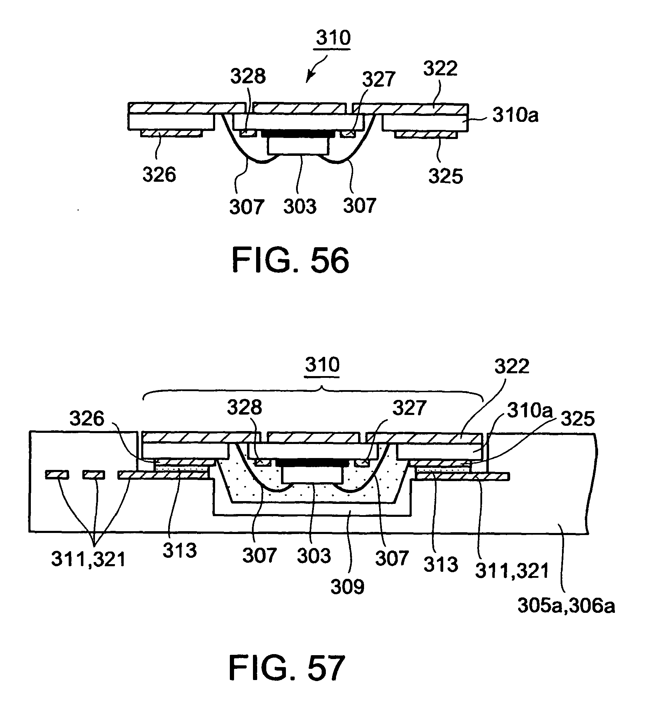

Fig. 56 is a sectional view of a dual interface IC module;
Fig. 57 is a sectional view of an IC card provided with the dual interface IC module;
Fig. 58 is a plan view of n IC card provided with a dual interface IC module, and a SIM;
Fig. 59 is a back view of an IC module in Example 5-1 for an IC card, in an example not covered by the claims;
Fig. 60 is a sectional view of a noncontact interface included in the IC module shown in Fig. 59;
Fig. 61 is a back view of an IC module in Example 5-2 for an IC card according to the present invention;
Fig. 62 is a sectional view of the noncontact interface connected to an IC chip;
Fig. 63 is a plan view of an IC card;
Fig. 64 is a plan view of an IC card;
Fig. 65 is a view of a SIM and
Fig. 66 is a view of a SIM holder.

### BEST MODE FOR CARRYING OUT THE INVENTION

The present invention relates in particular to a SIM. First, a SIM, i.e., an ID module, employed in the present invention will be described.

A SIM (ID module) employed in an embodiment of the present invention is the aforesaid SIM, UIM or USIM (hereinafter, "SIM" will be used as the general term for ID modules including UIMs and USIMs in the following description and claims) provided with an IC chip for contact and noncontact uses, i.e., an IC chip provided with a dual interface, and some embodiments employs an IC chip further provided with an antenna coil for noncontact communication.

The conventional contact SIM communicates with a PDA (personal digital assistant) in a contact communication mode through a terminal plate connected to the terminals of the PDA. The SIM of the present invention differs from the conventional contact SIM in communication mode.

The SIM (ID module) employed in the present invention to be used also as a prepaid card and a card for using transportation facilities holds identification codes, and information about the amount of money paid, the term of validity and the section for which the SIM is valid, in addition to information about the subscriber and information for personal identification for the settlement of credit account.

When the SIM is used also in combination with a portable telephone, the SIM is able to hold codes identifying private information including information about the subscriber and a telephone directory, and information for personal identification for the settlement of credit account.

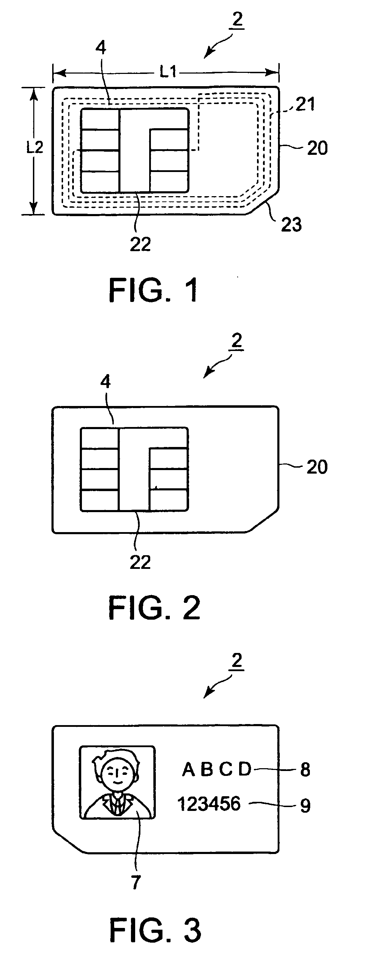

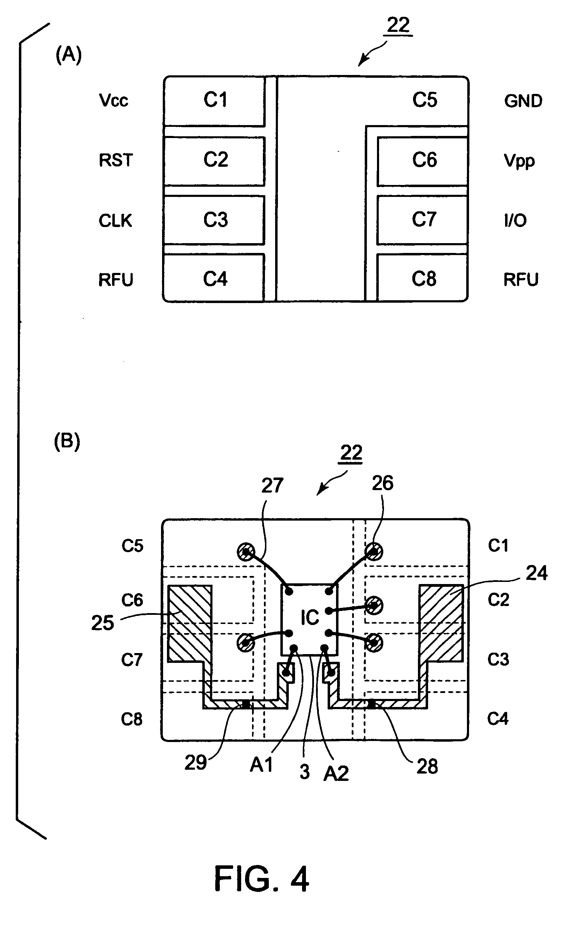

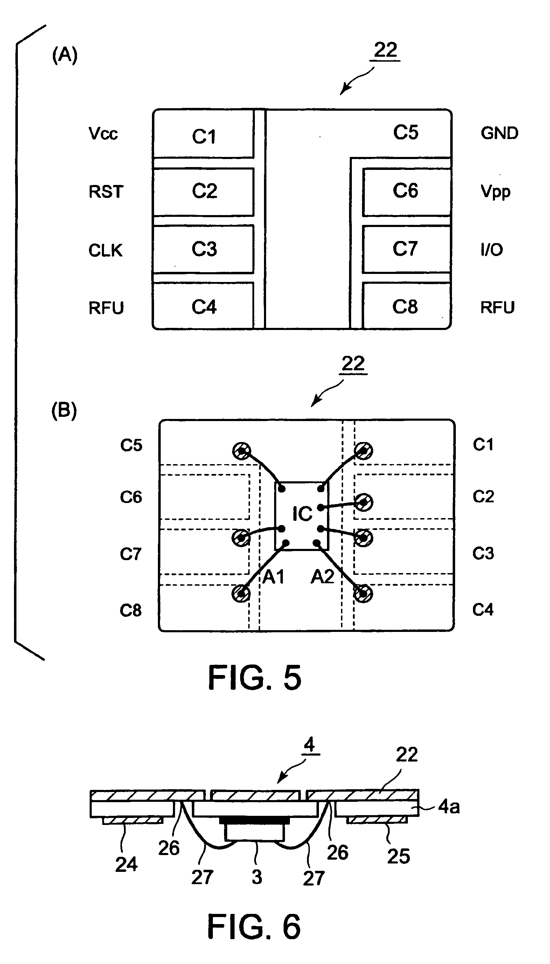

Fig. 1 is a view of a SIM in Example 1-1 of a first example not covered by the claims, Fig. 2 is a view of a SIM in Example 1-2 of the first example not covered by the claims, Fig. 3 is a view of a back surface of a SIM, Fig. 4 is a view of a contact-terminal plate included in the SIM in Example 1-1, Fig. 5 is a view of a contact-terminal plate included in the SIM in Example 1-2.

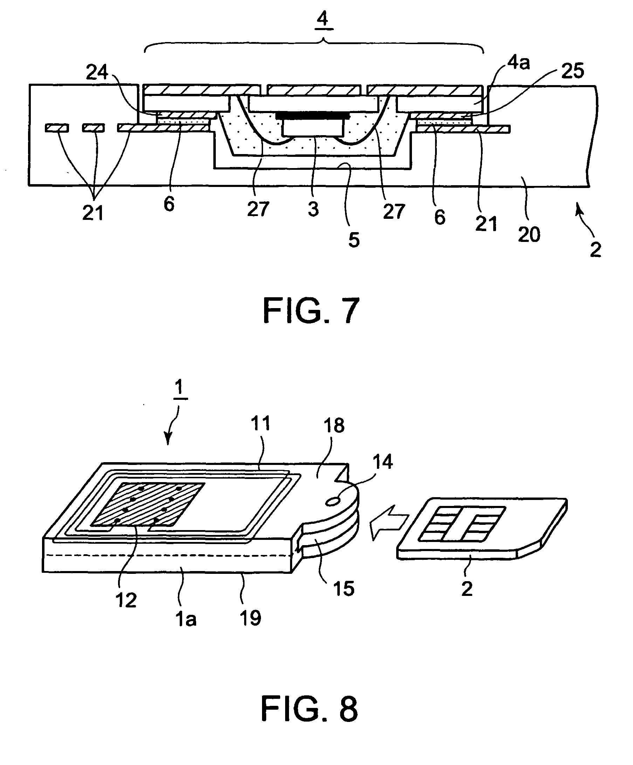

Fig. 6 is a sectional view in a plane including bonding wires of an IC module included in the SIM in Example 1-1, and Fig. 7 is a view of the IC module shown in Fig. 6 as incorporated into a SIM.

Referring to Fig. 1, a SIM 2 in Example 1-1 has an IC module 4 (Fig. 4) including a substrate 4a, an IC chip 3 mounted on the substrate 4a, and a contact-terminal plate 22 provided with a plurality of contact terminals C1 to C8 and mounted on the substrate 4a; and a SIM base 20 holding the IC module 4.

An antenna coil (SIM antenna coil) 21 is embedded in the SIM base 20 and is connected to the contact-terminal plate 22.

Generally, the SIM 2 has the shape of a thin rectangular plate having the long side L1 of about 25 mm, the short side L2 of about 15 mm, and the thickness of 1.0 mm or below (usually, 0.76 mm). A bevel 23 is formed by cutting one of the corners of the rectangular SIM 2 to facilitate the correct insertion of the SIM 2 in a SIM holder.

A rectangular shape includes such a rectangular shape having the bevel 23.

The SIM base 20, similarly to general IC cards, is formed of a plastic material.

The SIM is the same in appearance as general SIMs. The contact-terminal plate 22 is attached to the front surface of the SIM base 20, and the IC chip 30 is mounted on the back surface of the contact-terminal plate 22.

The sizes and the arrangement of the contact terminals on the contact-terminal plate 22 are determined in conformity with general IC card standards and the GSM (Global System for Mobile Cominunication).

The antenna coil 21 embedded in the SIM base 20 as shown in Fig. 1 may be formed by winding fine, conductive wires, by etching a conductive film or by printing a conductive line. Generally, the antenna coil 21 is formed by etching a metal sheet laminated to a core sheet, i.e., a central member of the SIM base 20.

The antenna coil 21 formed in the SIM base 20 has six to ten complete turns of a line. The opposite ends of the line forming the antenna coil 21 are connected through antenna-terminal plates 24 and 25 on the back surface of the IC module 4 to the C chip 3 (Fig. 6). The IC chip 3 of the IC module 4 is provided with a dual interface for both contact and noncontact uses.

As shown in Fig. 3, a half-length photograph 7, a name 8 and a number 9 are printed on the back surface of the SIM 2. Although the half-length photograph 7, the name 8 and the number 9 are not essential, they facilitate the identification of the possessor.

The half-length photograph 7, the name 8 and the number may be formed by sublimation transfer printing, ink-jet printing or mechanical engraving.

Fig. 4 (A) shows the front surface of the contact-terminal plate 22 of the SIM 2, and Fig. 4(B) shows wiring formed on the back surface of the contact-terminal plate 22. Actually, the wiring is coated with a resin layer formed by molding and hence Fig. 4(B) is a view taken through the resin layer.

The front surface of the contact-terminal plate 22 has a terminal function conforming to the standard 7816, ISO. As shown in fig. 4 (A) , eight contact terminals C1 to C8 are arranged on the front surface of the contact terminal plate 22.

The terminals C1, C2, C3, C5, C6 and C7 are a V_{cc} terminal, a RST terminal, a CLK terminal, a GND terminal, a Vₚₚ terminal and an I/O terminal, respectively, and the terminals C4 and C8 are RFU (reserved-for-future-use) terminals. Practically, the Vₚₚ terminal (variable supply voltage terminal) is not used.

The SIM holder 1 must be provided with at least five terminals to be connected to the contact terminals of the contact-terminal plate 22.

Referring to Fig. 4(B) the antenna-terminal plates 24 and 25 are formed on the back surface of the substrate 4a opposite the surface of the substrate 4a on which the contact-terminal plate 22 is mounted. Since the antenna coil 21 is embedded in the SIM base 20 of the SIM 2, the opposite ends of the embedded antenna coil 21 are electrically connected to the antenna-terminal plates 24 and 25 with a conductive adhesive or the like. These techniques are those generally applied to the manufacture of contact/noncontact IC cards.

Hatched parts in Fig. 4(B) are conductive parts formed of a metal. The antenna-terminal plates 24 and 25 are formed by using the back surfaces of the terminals C2 and C3, and the back surfaces of the terminals C6 and C7, respectively. The antenna-terminal plates 24 and 25 are connected to noncontact communication antenna terminals A1 and A2 of the IC chip 3 by wire bonding.

The antenna-terminal plates 24 and 25 are connected electrically to metal plates on the surfaces of the terminals C4 and C8 via through holes 28 and 29, respectively, to connect the antenna-terminal plates 24 and 25 to an antenna coil 11 included in the SIM holder 1.

The terminals C1, C2, C3, C5 and C7 to be connected to the contact terminals of the contact-terminal plate on the front surface are connected through openings formed in the substrate 4a to bonding pads 26 of the substrate 4a.

The contact terminals C1, C2, C3, C5 and C7 are not used when the SIM holder 1 is used for a normal use, and are used for writing data to the SIM by a contact reader/writer when the SIM is issued or renewed.

As shown in Fig. 6, the IC module 4 is formed by attaching the IC chip 3 to the substrate 4a by die bonding, and connecting the pads of the IC chip 3 and the pads 26 of the substrate 4a by bonding wires 27.

Referring to Fig. 7, in mounting the contact/noncontact IC module 4 on the SIM 2, the IC module 4 is placed in a recess 5 formed in the SIM base 20 so that a surface of the antenna coil 21 is exposed.

When the IC module 4 is thus placed in the recess 5, the antenna-terminal plates 24 and 25 formed on the lower surface of the IC module 4 are bonded to the antenna coil 21 of the SIM 2 with a conductive adhesive (or adhesive sheets) 6.

Referring to Fig. 2, a SIM 2 in Example 1-2 is not provided with any embedded antenna coil. Thus, the SIM 2 in Example 1-2 is the same in appearance as conventional SIMs for portable telephones. The SIM 2 employs an IC chip 3 provided with a dual interface for contact and noncontact communication. Fig. 3 shows the back surface of the SIM 2.

Fig. 5 (A) shows the front surface of a contact-terminal plate 22 included in the SIM 2, and Fig. 5(B) shows wiring formed on the back surface of the contact-terminal plate 22. Actually, the wiring, similarly to that shown in Fig. 4, is coated with a resin layer formed by molding.

The front surface of the contact-terminal plate 22 of the SIM 2 in Example 1-2 is the same in appearance as those of ordinary contact-terminal plates. The IC module 4 of the SIM 2 in Example 1-2 differs from the IC module shown in Fig. 4 in that terminals C4 and C8, i.e., RFU terminals, on the front surface are used for connecting an antenna coil 11 included in a SIM holder 1 to the antenna terminals A1 and A2 of a noncontact communication part of the IC chip 3.

The IC module 4 is mounted on a SIM base 20 by a method similar to that by which a contact IC card is fabricated.

A SIM holder 1 according to the present invention will be described.

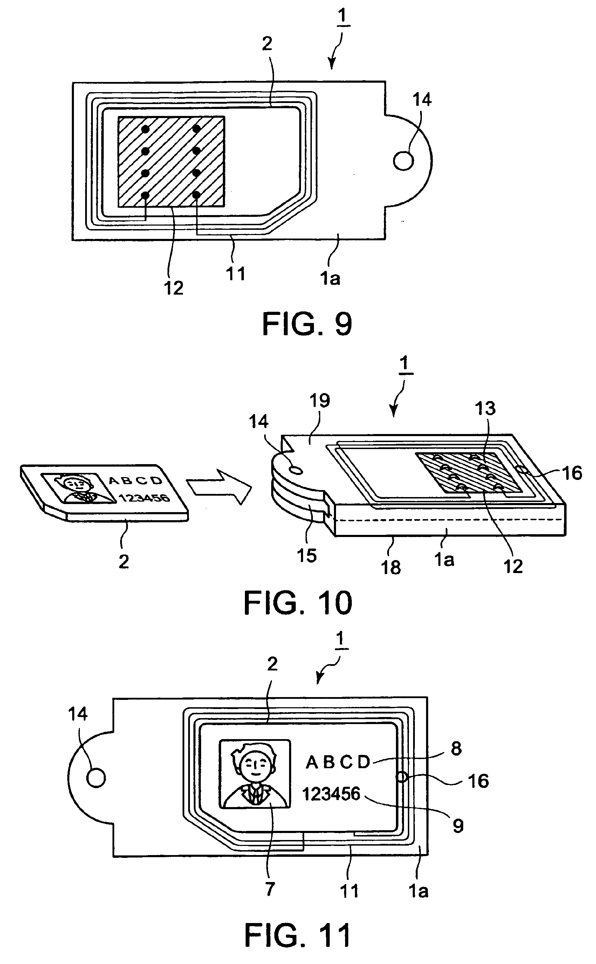

Fig. 8 is a front perspective view of assistance in explaining the use of a SIM holder, Fig. 9 is a top plan view of the SIM holder, Fig. 10 is a back perspective view of assistance in explaining the use of the SIM holder, and Fig. 11 is a bottom plan view of the SIM holder.

As shown in Fig. 8, the SIM holder 1 is a key holder type holder having a case 1a. The SIM 2 is inserted through a slot 15 in the case 1a.

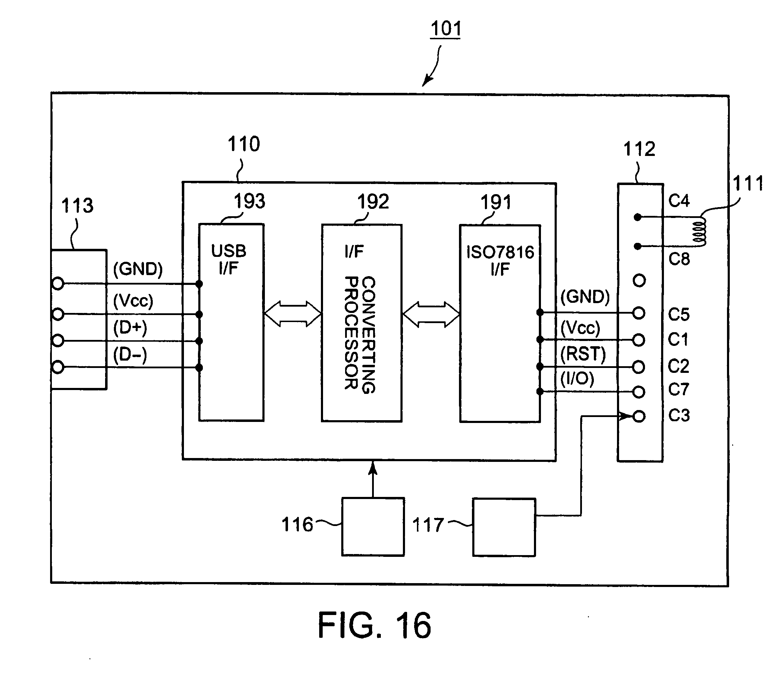

When the SIM 2 is inserted in the case 1a, the SIM 2 is held fixedly in the SIM holder 1 by a locking device with the contact-terminal plate 22 of the SIM 2 in contact with a terminal plate 12 included in the SIM holder 1. When the SIM 2 needs to be extracted from the SIM holder 1, the SIM 2 can be released from the locking device by inserting the tip of a ballpoint pen in a small hole 16 (Fig. 16), and can be ejected from the SIM holder 1 by a plate spring or the like.

Accidental ejection of the SIM 2 from the SIM holder 1 can be prevented by passing a chain ring, not shown, through a hole 14.

As shown in Fig. 9, the case 1a of the SIM holder 1 is provided with an antenna coil 11 that surrounds the SIM 2 inserted in the case 1a . The antenna coil 11 may be formed by winding a conductive wire, printing a conductive line or etching a conductive film.

In most cases, the case 1a of the SIM holder 1 is formed of a plastic material and consists of an upper case (cover) 18 and a lower case 19. A terminal plate 12 and a printed substrate for holding the terminal plate 12 are placed in the lower case 19, and then the upper case 18 is joined to the lower case 19 so that pins, not shown, formed on the upper case 18 and the lower case 19 are engaged in corresponding holes, not shown, formed in the upper case 18 and the lower case 19, respectively.

The antenna coil 11 may be formed on the inner surface of the upper case 18 or the lower case 19 before joining together the upper case 18 and the lower case 19. The antenna coil 11 may be formed on a printed substrate for holding the terminal plate 12 by etching a conductive film or by printing a conductive line. The antenna coil 11 is connected to the terminals C4 and C8 of the terminal plate 12 by suitable wiring means.

The reliability of communication can be improved and communication range can be increased by forming the antenna coil 11 as close to the antenna coil 21 of the SIM 2 as possible in a plane around the antenna coil 21 where any wiring lines and metallic parts of the SIM holder 1 are not arranged.

Whereas the antenna coil 11 is an indispensable component of the SIM holder 1, the SIM 2 may be either provided or not provided with the antenna coil 21.

If the SIM 2 is not provided with the antenna coil 21, the antenna coil 11 of the SIM holder 1 is connected through the terminals C4 and C8 of the terminal plate 12 to the IC chip 3 provided with the dual interface for contact and noncontact uses of the SIM 2. In such a case, the terminal plate shown in Fig. 5 is used.

If the SIM 2 is provided with the antenna coil 21, both the antenna coil 11 of the SIM holder 1 and the antenna coil 21 of the SIM 2 are connected to the noncontact communication antenna terminals A1 and A2 of the IC chip 3. The antenna coil 21 of the SIM 2 is connected through the antenna-terminal plates 24 and 25 to the IC chip 3, and the antenna coil 11 of the SIM holder 1 is connected through through holes 28 and 29 formed in the terminals C4 and C8 to the IC chip 3. In such a case, a terminal plate shown in Fig. 4 is used.

Since the SIM 2 is small, it is difficult to form the antenna 21. Since the antenna 21 is inevitably small and has a small number of turns of lines, it is difficult to increase communication range. The use of the antenna coil 11 of the SIM holder 1 in combination with the antenna 21 of the SIM 2 provides the same effect as increase in the number of turns of the wire of the antenna coil 11, and the affinity of the SIM 2 to the noncontact reader/writer can be improved.

Referring to Fig. 10, the terminal plate 12 of the SIM holder 1 is provided with eight contact pins 13 that correspond to the contact-terminal plate 22 of the SIM 2. The opposite ends of the antenna coil 11 are connected to the terminals C4 and C8, respectively.

When the case 1a of the SIM holder 1 is formed of a transparent resin, the half-length photograph 7, the name 8 and the number 9 printed on the SIM 2 inserted in the SIM holder 1 can be recognized as shown in Fig. 11, which facilitates the identification of the possessor.

Plastic materials suitable for forming the case 1a include acrylic resins, polycarbonate resins, polyolefin resins including polypropylene resins and polyethylene resins, polystyrene resins and polyvinyl chloride resins.

When the SIM holder 1 is formed in a thickness of 10 mm or below, a width of 25 mm or below and a length of 50 mm or below, the SIM holder 1 is small and easy to carry.

A method of using the SIM holder 1 will be described.

The user does not need to operate a button or the like on the SM holder 1 to make the SIM 2 held in the SIM holder 1 communicate directly with an external device.

The user of the SM holder 1 is able to buy prepaid items including cigarettes, beverages, gasoline and admission tickets.

The SIM 2 can be replaced with a SIM for a portable telephone.

The SIM of the present invention can be manufactured by a conventional method of manufacturing IC cards.

The SIM has an advantage of enabling a personalizing issuing process that is performed before the bridged SIMs are separated into wallet-sized IC cards.

The half-length photograph, the name and the number can be printed on the back surface of the terminal plate of the SIM and an ID module having the shape of a small SIM can be formed. A SIM holder formed of a transparent resin, the half-length photograph of the ID module can visually be recognized through the SIM holder.

The above described SIM can be used on a portable telephone. Some portable telephones are provided with a dual interface. The SIM communicates with a portable telephone through contact terminals. The SIM mounted on a portable telephone is unable to use an infrastructure for noncontact IC cards. If the SIM mounted on a portable telephone is removed from the portable telephone and is inserted in the SIM holder when necessary, the infrastructure for noncontact IC cards can easily be used.

The SIM holder is provided with the antenna coil formed in a loop greater than that of the antenna coil of the SIM and the number of turns of lines of the antenna coil of the SIM holder can comparatively freely be determined. Thus, the affinity of the SIM holder to the noncontact reader/writer can be improved.

The SIM holder has the shape of a small key holder, the SIM holder can be connected to the strap of a portable telephone to carry the same together with the portable telephone. When the SIM needs to be used in connection with the infrastructure of a noncontact IC card, the SIM can be removed from the portable telephone and can easily be mounted on the SIM holder.

Second Example not covered by the claims.

A SIM (ID module) employed is the aforesaid SIM, UIM or USIM (hereinafter, "SIM" will be used as the general term for ID modules including UIMs and USIMs in the following description and claims) provided with an IC chip for both contact and noncontact uses, i.e., an IC chip provided with a dual interface.

The term "SIM" will be used as the general term for small ID modules of sizes corresponding to those of plug-in SIMs specified in GSM.1111 or 3GPPTS11.11. The function of the SIM is not limited to that of the aforesaid subscriber identification device for a portable telephone. Sometimes, the term "UIM" will be used instead of "SIM".

A second example not covered by the claims will be described with reference to the accompanying drawings.

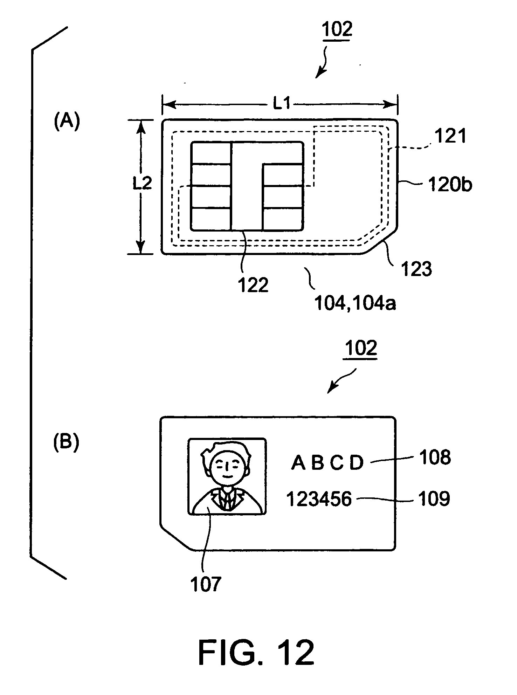

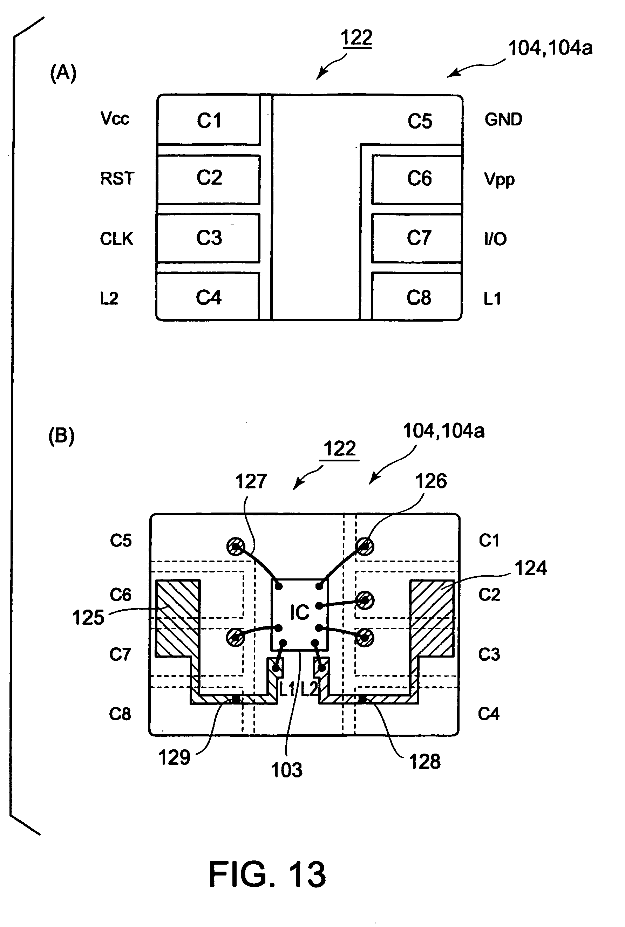

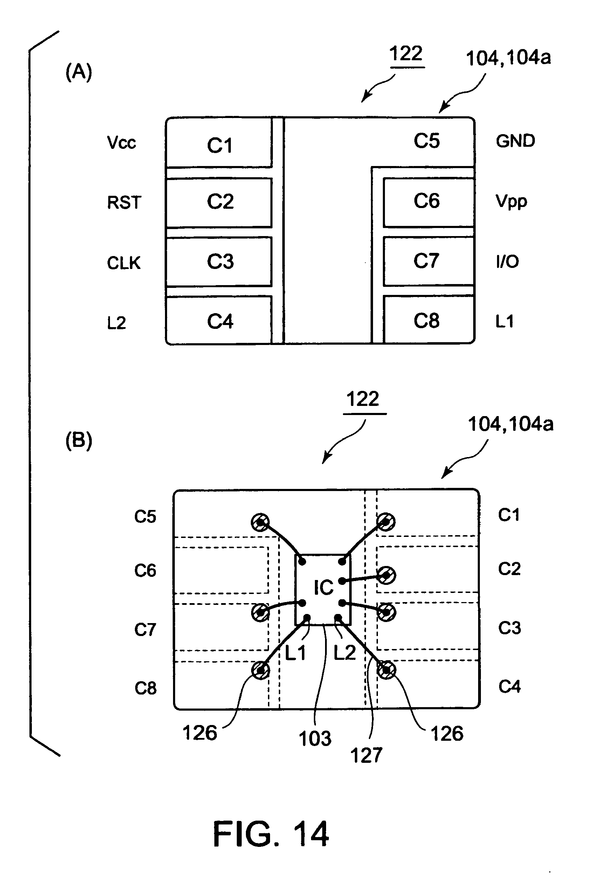

Fig. 12 is a view of a SIM in the second example, Fig. 13 is a view of an IC module in Example 2-1 employed in the SIM in the second example, and Fig 14 is an IC module in Example 2-2.

The SIM of this example is the same in appearance as general SIMs. A SIM 102 comprises an IC module 104 including a substrate 104a, an IC chip 103 mounted on the substrate 104a, and a contact-terminal plate 122 provided with a plurality of contact terminals C1 to C8 and mounted on the substrate 104a; and a SIM base 120b holding the IC module 104.

The contact-terminal plate 122 is mounted on the front surface of the IC module 104, and the modularized IC tip 103 is mounted on the back surface of the contact-terminal plate 122. The sizes and the arrangement of the contact terminals on the contact-terminal plate 122 are determined in conformity with general IC card standards and the GSM (Global System for Mobile Communication).

The SIM 102 may be provided with an antenna coil 121 embedded in the SIM base 120b and connected to the contact-terminal plate 122. An antenna coil 111 is an indispensable component of a SIM holder 101 of the present invention. The noncontact communication ability can be enhanced by providing SIM 102 with an antenna coil 121.

The antenna coil 121 may be formed by winding a fine wire, by etching a conductive film or by printing a conductive line. In most cases, the antenna coil 121 is formed by etching a metal sheet laminated to a core sheet (central layer of the SIM base 120b) of the SIM 102. The antenna coil 121 has six to ten turns of a conductive line formed in the SIM base 120b. The opposite ends of the antenna coil 121 are connected through antenna-terminal plates 124 and 125 formed on the back surface of the IC module 104 to the IC chip 103.

The IC chip 103 of the IC module 104 is provided with a dual interface for contact and noncontact communication.

As shown in Fig. 12(A), the SIM 102 has the shape of a thin rectangular plate having the long side L1 of about 25 mm, the short side L2 of about 15 mm.

The thickness of the SIM 102 is 1.0 mm or below (usually, 0.76 mm). A bevel 123 is formed by cutting one of the corners of the rectangular SIM 102 to facilitate the correct insertion of the SIM 102 in a SIM holder 101.

A rectangular shape includes such a rectangular shape having the bevel 123. The SIM base 120b, similarly to general IC cards, is formed of a plastic material.

Any parts are not mounted on the back surface of the SIM 102. As shown in Fig. 12, a half-length photograph 107, a name 108 and a number 109 may be printed on the back surface of the SIM 102. Although the half-length photograph 107, the name 108 and the number 109 are not essential, they facilitate the identification of the possessor.

The half-length photograph 107, the name 108 and the number 109 may be formed by sublimation transfer printing, ink-jet printing or mechanical engraving.

Figs. 13 is a view of an IC module 102 in Example 2-1 employed in the SIM 102. Fig. 13 (A) is a view of the front surface of a contact-terminal plate 122 included in the IC module 104, and Fig. 13(B) is a view of wiring formed on the back surface of the contact-terminal plate 122.

As shown in Fig. 13(A), eight terminals C1 to C8 are formed on the front surface of the contact-terminal plate 122. The terminals C1, C2, C3, C5, C6 and C7 are a V_{cc} terminal, a RST terminal, a CLK terminal, a GND terminal, a Vₚₚ terminal and an I/O terminal, respectively, and the terminals C4 and C8 are L2 and L1 terminals, respectively, to be connected to the antenna coil of the SIM holder.

Practically, the Vₚₚ terminal (variable supply voltage terminal) is not used.

As shown in Fig. 13(B), antenna-terminal plates 124 and 125 are formed on the back surface of the contact-terminal plate 122. The antenna-terminal plates 124 and 125 are used when an antenna coil 121 is embedded in the base 120b of the SIM 102. The opposite ends of the embedded antenna coil 121 are connected electrically to the antenna-terminal plates 124 and 125 with a conductive adhesive or the like. Such an arrangement is the same as that of an IC card provided with a dual interface.

Hatched parts in Fig. 13(B) are conductive parts formed of a metal. The antenna-terminal plates 124 and 125 are formed in parts of the back surface of the contact-terminal plate 122 corresponding to the terminals C2 and C3, and corresponding to the terminals C6 and C7, respectively. The antenna-terminal plates 124 and 125 have parts passing the terminals C4 and C8 are connected to the noncontact communication antenna terminals (parts for noncontact communication) L1 and L2 of the IC chip 103 by wire bonding.

The antenna-terminal plates 124 and 125 are connected electrically to metal plates formed on the surfaces of the terminals C4 and C8 through through holes 128 and 129 to connect the antenna-terminal plates 124 and 125 to the antenna coil 121 of the SIM 102.

The components of the wiring excluding the antenna-terminal plates 124 and 125 are coated with a resin coat formed by molding. Fig. 13(B) is a view taken through the resin coat.

The terminals C1, C2, C3, C5 and C7 to be connected to the contact terminals of the contact-terminal plate on the front surface are connected through openings formed in the substrate 104a bonding pads 126 and bonding wires 127 to the IC chip 103.

The contact terminals C1, C2, C3, C5 and C7 are connected to an interface-converting IC to exercise predetermined functions, and are connected to a contact reader/writer for writing data to the SIM 102 by the contact reader/writer when the SIM 102 is issued or renewed.

If the SIM 102 is provided with the antenna coil 121, both the antenna coil 111 of the SIM holder 101 and the antenna coil 121 of the SIM 102 are connected to the noncontact communication antenna terminals L1 and L2 of the IC chip 103. The antenna coil 121 of the SIM 102 is connected through the antenna-terminal plates 124 and 125 to the IC chip 103, and the antenna coil 111 of a SIM holder 101 is connected through the terminals C4 and C8 and the through holes 128 and 129 to the IC chip 103.

Since the SIM 102 is small, it is difficult to form the antenna 121. Since the antenna 121 is inevitably small and has a small number of turns of lines, it is difficult to increase communication range. The use of the antenna coil 111 of the SIM holder 101 in combination with the antenna 121 of the SIM 102 provides the same effect as increase in the number of turns of the wire of the antenna coil 111, and the affinity of the SIM 102 to external devices can be improved.

Fig. 14 shows an IC module in Example 2-2 employed in the SIM. Fig. 14(A) is a view of the front surface of a contact-terminal plate, and Fig. 14 (B) is a view of a back surface of the contact-terminal plate provided with wiring. The IC module in Example 2-2 is used in combination with a SIM not provided with any antenna coil.

The front surface of a contact-terminal plate 122 is the same as that employed in Example 2-1. As shown in Fig. 14 (A), eight terminals C1 to C8 are formed on the contact-terminal plate 122. The terminals C1, C2, C3, C5, C6 and C7 are a V_{cc} terminal, a RST terminal, a CLK terminal, a GND terminal, a Vₚₚ terminal and an I/O terminal, respectively.

The terminals C4 and C8 are L2 and L1 terminals to be connected to the antennal coil 111 of the SIM holder 101.

As shown in Fig. 14 (B), any antenna-terminal plate is not mounted on the back surface of the contact-terminal plate 122, because a SIM 102 is not provided with any antenna coil. Bonding pads 126 are formed on the back surfaces of the terminals C4 (L2) and C8(L1). The terminals C4 and C8 are connected to the noncontact communication antenna terminals (parts for noncontact communication) L1 and L2 of the IC chip 103 by wire bonding.

The SIM holder 101 will be explained.

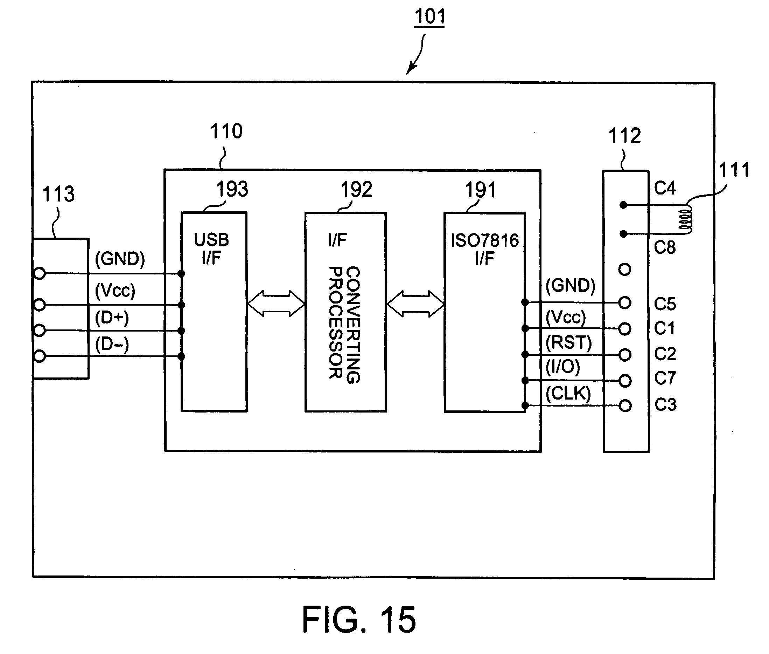

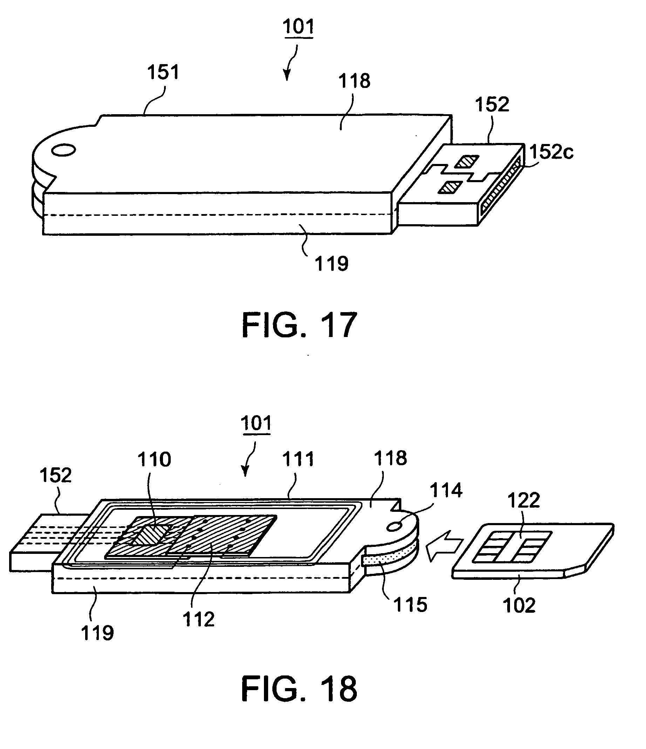

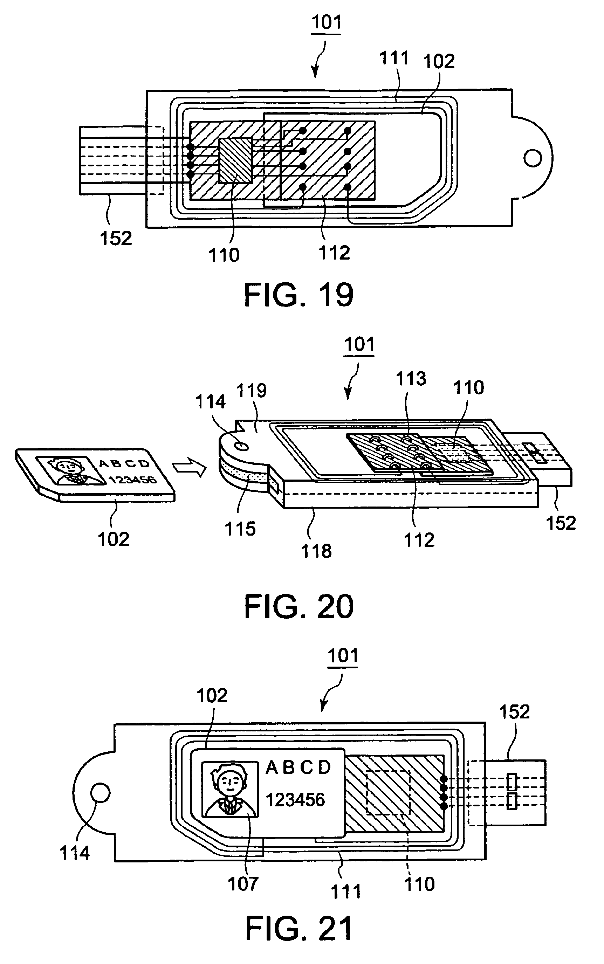

Fig. 15 is a block diagram of a SIM holder, Fig. 16 is a block diagram of a SIM holder in another example, Fig. 17 is a perspective view of a SIM holder, Fig. 18 is a front perspective view of a SIM and a SIM holder, Fig. 19 is a top plan view of a SIM holder holding a SIM, Fig. 20 is a back perspective view of a SIM and a SIM holder, and Fig. 21 is a bottom plan view of a SIM holder holding a SIM.

Referring to Fig. 15, a SIM holder 101 has a contact-terminal plate 112 to be connected to a SIM, an interface-converting IC 110, a USB connector 113, and an antenna coil 111.

The interface-converting IC 110 is an IC chip capable of converting signals provided by the SIM into signals of a protocol and format conforming to the USB connector 113. The interface-converting IC 110 includes an interface 191 conforming to ISO 7816, an I/F converting processor 192 and a USB interface 193.

Data transmission rate based on the USB standards is 12 Mb/s, which is far higher than data transfer rate of 38 kb/s at which data is transferred through an I/O pad using a protocol and a format defined by ISO 7816.

The terminals C4 and C8 of the SIM 102 are connected to the antenna coil 111 of the SIM holder 101 and the antenna coil 121 of the SIM 102. The terminals C4 and C8 are connected only to the antenna coil 111 of the SIM holder 101 when the SIM 102 is not provided with the antenna coil 121. The terminals C5 (GND), C1 (V_{cc}), C2 (RST), C7 (I/O) and C3 (CLK) of the SIM 102 are connected to the interface 191 of ISO 7816 of the interface-converting IC 110.

The USB interface 193 is connected through the USB connector 113 to a PC (personal computer) for the connection of GND and V_{cc}, and for exchanging signals D+ and D- for transmission according to a protocol defined by the USB standards.

In the SIM 102, USB connector lines and the interface-changing IC 110 share GND, V_{cc} and CLK. The CLK of the interface-changing IC 110 is generated from D+ and D-.

Any problem does not arise even if GND and V_{cc} are connected directly to the terminals C5 and C1 by the USB connector.

Fig. 16 is a block diagram of a SIM holder 101 in another example. This SIM holder 101 is provided with oscillators 116 and 117 in addition to the components corresponding to those of the SIM holder 101 shown in Fig. 15.

The oscillators 116 and 117 are used to stabilize the operation of an interface-converting IC 110. For example, the frequencies of signals generated by the oscillators 116 and 117 are 6 MHz and 3.57 MHz, respectively.

The working frequency of the oscillator 116 may be in the range of 4 to 20 MHz. The oscillator 117 conforms to the ISO standards for SIMs and IC cards.

In Figs. 17 to 21, the oscillators are not shown, capacitors and resistors which can readily be thought to be included in the circuits by persons having knowledge of electric circuits are omitted, and the drawings will include only parts necessary for showing the requirements of the present invention.

Referring to Fig. 17 showing the SIM holder 101 in a perspective view, the SIM holder 101 has a case 151 formed by molding a plastic material, and a metal plug 152 attached to the case 151.

The plug 152 defines an opening 152c, and the terminals GND, V_{cc}, D+ and D- are arranged in the opening 152c. The plug 152 is inserted in a receptacle formed in a PC for data communication.

The SIM 102 is inserted in the SIM holder 101 through an opening at the left end, as viewed in Fig. 17, of the SIM holder 101. The SIM 102 can be removed from the SIM holder 101. In the normal sate, the SIM 102 is connected to the contact-terminal plate 112 when the SIM holder 101 is used.

In most cases, the plastic case 151 of the SIM holder 101 has the shape of a key holder and has an upper case 118 (cover) and a lower case 119. The contact-terminal plate 112 and a printed substrate holding the contact-terminal plate 112 are contained in the case 151. The upper case 118 and the lower case 119 are joined together so that pins, not shown, formed on the upper case 118 and the lower case 119 are engaged in corresponding holes, not shown, formed in the upper case 118 and the lower case 119, respectively.

Fig. 18 is a perspective view of the SIM 102 and the SIM holder 101. In Fig. 18, the wiring can be seen through the SIM holder 101.

The SIM 102 inserted through a slot 115 in the SIM holder 101 is held under the contact-terminal plate 112 and is filed in place by a locking device, not shown. In this state, the contacts of the contact-terminal plate 122 of the SIM 102 are in contact with the corresponding terminals of the contact-terminal plate 112 of the SIM holder 101, and the terminals C4 and C8 of the contact-terminal plate 122 are connected to the antenna coil 111 of the SIM holder 101 and, if the SIM 102 is provided with an antenna coil, the terminals C4 and C8 are connected also to the antenna coil of the SIM 102.

The case 151 contains the antenna coil 111, the contact-terminal plate 112, the interface-converting IC 110 and, when necessary, oscillators, not shown.

As shown in Fig. 19, the antenna coil 111 of the SIM holder 101 are formed such that the antenna coil 111 surrounds the SIM 102 inserted in the SIM holder 101. The antenna coil 111 may be formed by winding fine, conductive wires, by etching a conductive film or by printing a conductive line.

The antenna coil 111 may be formed on the inner surface of the upper case 118 or the lower case 119. The antenna coil 111 may be formed on the printed substrate holding the interface-converting IC 110 and the contact-terminal plate 112 by etching a conductive film or printing a conductive line. Preferably, the winding line of the antenna coil 111 extends substantially along the peripheral edges of the SIM 102 inserted in the SIM holder 101.

The antenna coil 111 is connected to the terminals C4 and C8 of the contact-terminal plate 112 by suitable wiring means.

As shown in Fig. 20, the contact-terminal plate 112 of the SIM holder 101 is provided with eight contact pins 113 respectively corresponding to the terminals of the contact-terminal plate 122 of the SIM 102. The opposite ends of the antenna coil 111 are connected to the terminals C4 and C8, respectively. Fig. 21 shows the back surface of the SIM holder 101. When the case 151 of the SIM holder 101 is formed of a transparent resin, the half-length photograph 107, the name 108 and the number 109 printed on the SIM 102 can visually be recognized, which facilitates the identification of the possessor.

Plastic materials suitable for forming the case 151 include acrylic resins, polycarbonate resins, polyolefin resins including polypropylene resins and polyethylene resins, polystyrene resins and polyvinyl chloride resins.

When the SIM holder 101 is formed in a thickness of 10 mm or below, a width of 25 mm or below and a length of 50 mm or below, the SIM holder 101 is small and easy to carry.

A method of using the SIM holder 101 will be explained.

The SIM 102, similarly to the conventional IC card, is issued after writing data for identifying the possessor to the SIM 102.

The SIM 102 inserted in the SIM holder 101 of the present invention functions as a noncontact ID module for noncontact communication. The SIM 102 can singly be used as a contact IC module in combination with external devices, such as door locks and ticket gates, for contact communication.

The SIM functions as a USB interface ID module when connected to the USB connector of a PC. When the SIM 102 is authenticated, the possessor is able to access the network. Thus, unauthenticated persons are prevented from accessing the network. The authentication of the SIM 102 does not need any IC card reader/writer, which is needed when an IC card is used.

Whereas the conventional ID module is formed by combining a USB interface and a microcomputer, the SIM holder 101 and the SIM 102 are separate devices that can be combined, when necessary, to form an ID module. The SIM holder 101 provided with the antenna coil can be used not only as a USB ID module, but also as a noncontact ID module.

Thus, the ID module which could have been used only for accessing the network can be used also as an ID module for operating a door lock and a personnel identifying means.

The SIM can be manufactured by a bridge process included in a conventional IC card manufacturing method that forms a sheet consisting of a plurality of wallet-sized SIMs connected by small bridges.

Visible data including the half-length photograph, the name and the number can be printed on the back surface of the SIM, an ID module having the shape of a small SIM can be formed, and the visible data printed on the back surface of the SIM can be recognized through the transparent SIM holder when the SIM is inserted in the SIM holder, and the combination of the SIM and the SIM holder can be used as an ID module.

### First Embodiment

As mentioned above, the present invention relates to an IC module provided with three kinds of interfaces (sometimes, referred to as "IC module of the present invention"), a three-way SIM and a SIM holder, a three-way IC card and an IC card holder. First, an IC module of the present invention will be described.

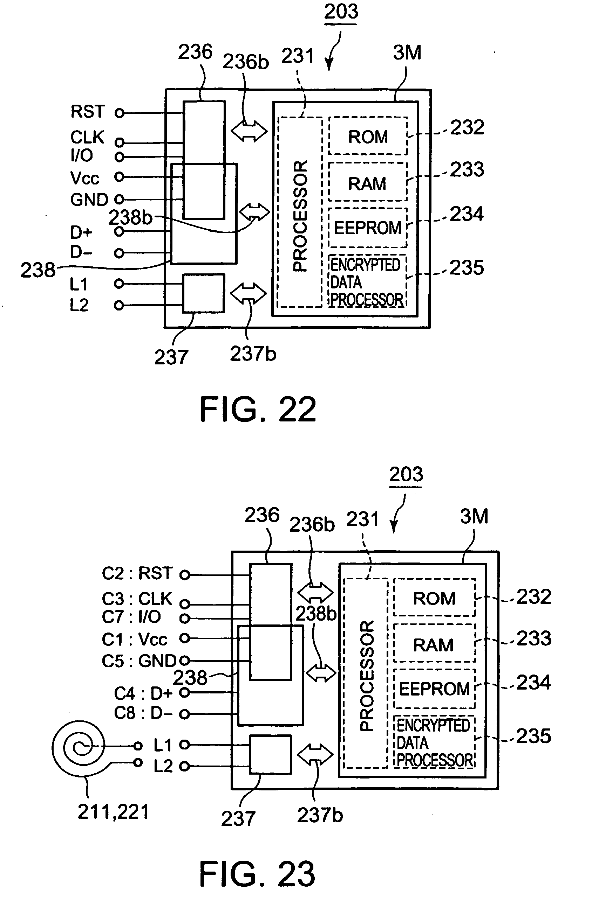

Fig. 22 is view of assistance in explaining an IC chip to be included in an IC module in a first embodiment according to the present invention, Fig. 23 is a view of assistance in explaining the relation between the terminals (pads) of the IC chip and a contact-terminal plate.

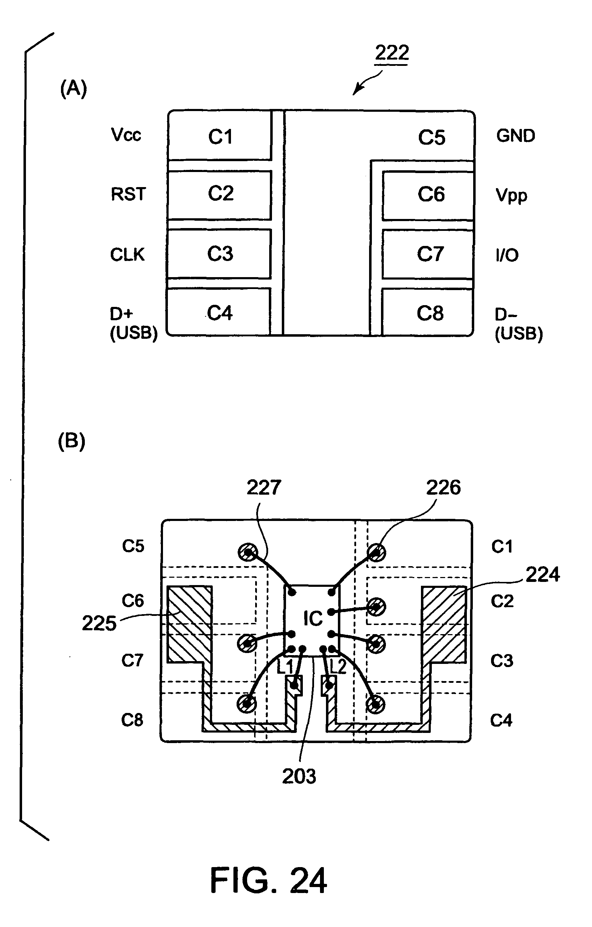

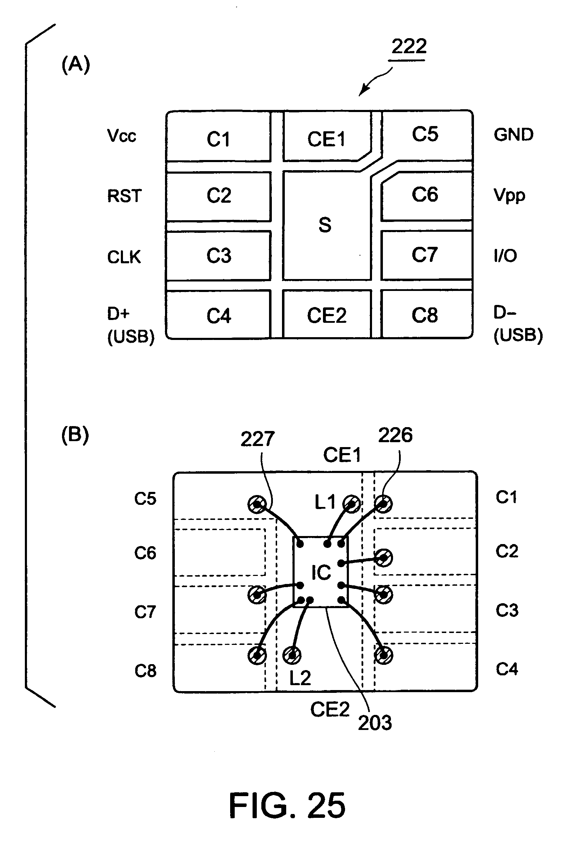

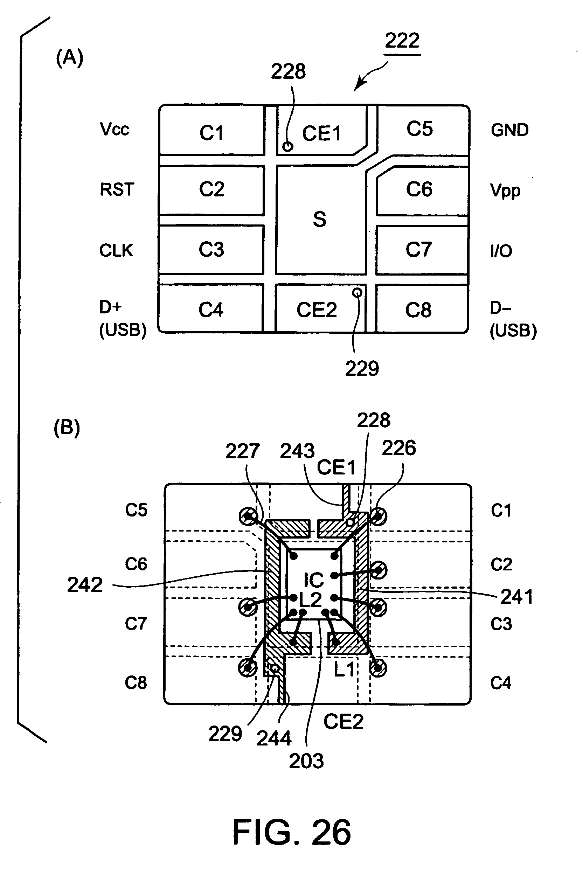

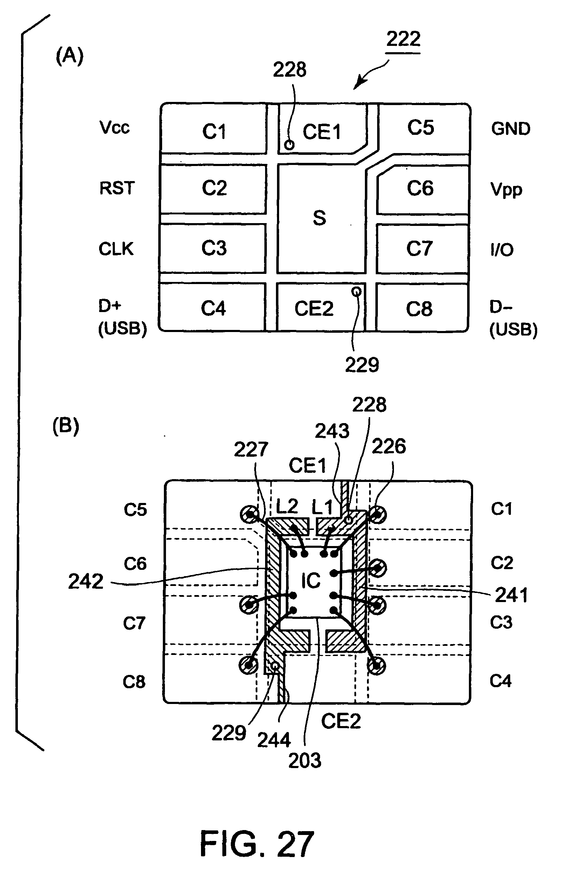

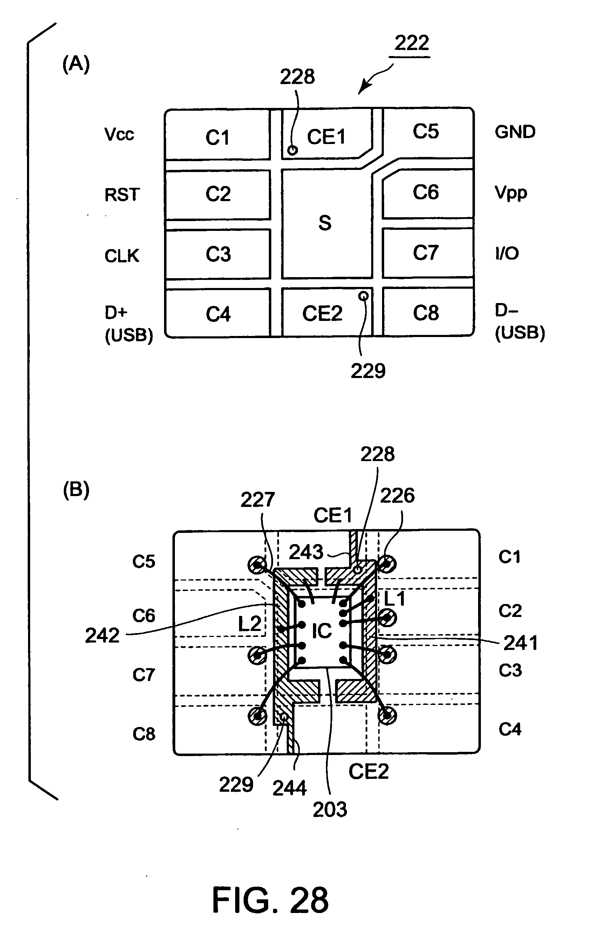

Fig. 24 is a view of an IC module in Example 3-1 not covered by the claims, Fig. 25 is a view of an IC module in Example 3-2 not covered by the claims, Fig. 26 is a view of an IC module in Example 3-3, Fig. 27 is a view of an IC module in Example 3-4 and Fig. 28 is a view of an IC module in Example 3-5.

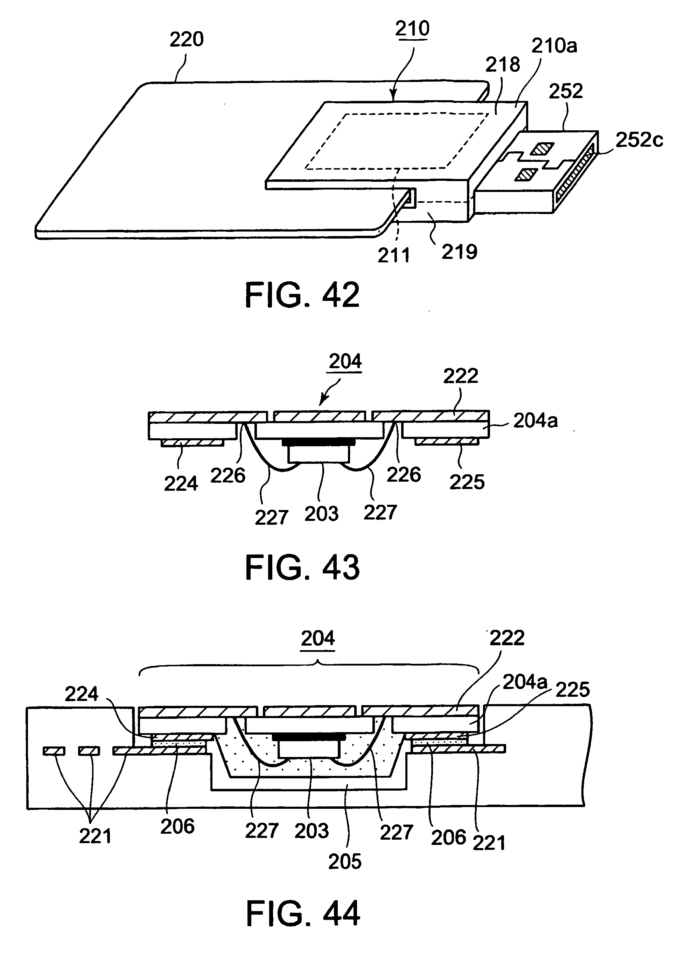

An IC module 204 has a substrate 204a, an IC chip 203 mounted on the substrate 204a, and a contact-terminal plate 222 mounted on the substrate 204a (Figs. 43 and 44). As shown in Fig. 22, the IC chip 203 of the IC module 204 has a microcomputer 3M comprising a processor 231, a nonvolatile memory (ROM) 232, a volatile memory (RAM) 233, an electrically erasable programmable nonvolatile memory (EEPROM) 234 and, preferably, a cryptic data processor 235. The ROM 232, the RAM 233, the EEPROM 234 and the encrypted data processor 235 are connected to the processor 231.

The cryptic data processor 235 decrypts input information to provide information of a noncryptic format, and encrypts information of the noncryptic format to provide cryptic information. The cryptic data processor 235 is indispensable for cryptocommunication using SIMs and IC cards.

The IC chip 103 further comprises a contact interface 236 conforming to ISO 7816-2 and ISO 7816-3, a noncontact interface 237 conforming to ISO 14443 and a USB contact interface 238.

ISO 7816-2, ISO 7816-3, and ISO 14443 correspond to JIS X6303, JIS X6304 and JIS X6322, respectively.

The interfaces 236, 237 and 238 are connected t the processor 231 by control buses 236b, 237b and 238b, respectively.

The contact interface 236 has five terminals (pads), namely, RST, CLK, I/O, V_{cc} and GND terminals, and is connected to a terminal plate. The USB contact interface 238 has four terminals (pads), namely, V_{cc}, GND, D+ and D- terminals. The contact interface 236 and the USB contact interface 237 share the v_{cc} and GND terminals. The noncontact interface 237 has antenna terminals (pads) L1 and L2.

Fig. 23 similar to Fig. 22 shows the relation between the terminals (pads) of the IC chip 203 , and a contact-terminal plate.

The RST, CLK, I/O, Vcc and GND terminals are connected to terminals C2, C3, C7, C1 and C5, respectively. The terminals D+ and D- of the USB contact interface 238 are connected to terminals C4 and C8, respectively, and the antenna terminals L1 and L2 are connected to antenna coils 211 and 221. The antenna coil 211 is included in a SIM holder 201 or an IC card holder 210, and the antenna coil 221 is included in the SIM 202 or an IC card 220.

Fig. 24 is a view of an IC module in Example 3-1 and Fig. 25 is a view of an IC module in Example 3-2. Figs. 24(A) and 25(A) are views of contact-terminal plates 222 included in the IC modules in Examples 3-1 and 3-2, respectively.

Referring to Fig. 24(A), the contact-terminal plate 222 of the IC module in Example 3-1 has terminals C1 to C8 conforming to ISO 7816. The terminals C4 and C8 are used as the D+ and D- terminals of the USB contact interface.

Practically, the terminal C4, i.e., a Vₚₚ terminal (variable supply voltage terminal), is not used.

Referring to Fig. 24(B), the contact-terminal plate 222 of the IC module in Example 3-1 is provided on its back surface with antenna-terminal plates 224 and 225. The antenna-terminal plates 224 and 225 are formed in parts of the back surface of the IC module corresponding to the terminals C2 and C3, and corresponding to the terminals C6 and C7, respectively. The antenna-terminal plates 224 and 225 extend along the back surfaces of the terminals C4 and C8 and are connected to noncontact communication antenna terminals L1 and L2 of an IC chip 203 by bonding wires 227.

The terminals C4 and C8 are connected through pads 226 to the USB interface of the IC chip 203 by wire bonding.

The IC module 204 in Example 3-1 is provided with the antenna coil 221 formed in a SIM 202 or an IC card 20. Preferably, the antenna terminals L1 and L2 are formed near the lower side of the IC chip 203.

Hatched parts in Fig. 24(B) are conductive parts formed of a metal. Parts shown in Fig. 24(B) including the IC chip 203 and bonding wires and excluding the antenna-terminal plates 224 and 225 are coated with a resin coating by molding. Therefore, Fig. 24(B) shows a view through the resin coat.

Those apply similarly to Figs. 25 to 28 and hence the description of the same matters will be omitted.

Referring to Fig. 25(A), a contact-terminal plate 222 of an IC module in Example 3-2 has terminals C1 to C8 conforming to ISO 7816. The terminals C4 and C8, similarly to those of the IC module in Example 3-1, are used as the D+ and D- terminals of a USB contact interface.

The IC module in Example 3-2 is featured by extra contact terminals CE1 and CE2 disposed between the terminals C1 and C5 and between the terminals C4 and C8, respectively.

Parts of a metal film corresponding to grooves between the adjacent terminals in Fig. 25(A) are removed by etching to form nonconductive parts. The terminal C5, i.e., a GND terminal, is connected to a central region S to form the terminal C5 in a large area. The terminal C5 does not need necessarily to be connected to the central region S.

Fig. 25 (B) is a view of the back surface of the contact-terminal plate 222 of the IC module in Example 3-2. Any antenna-terminal plates are not formed on the back surface of the contact-terminal plate 222. The extra contact terminals CE1 and CE2 are connected through pads 226 to the noncontact communication antenna terminals L1 and L2 of an IC chip 203 by bonding wires 227. Any through holes are not used.

The IC chip 203 may be provided with a connecting circuit, not shown, and may be connected through through holes to the extra contact terminals CE1 and CE2 by the connecting circuit.

In the IC modules in those examples, a SIM 202 or an IC card holder 220 is not provided with any antenna coil, and the IC modules are connected to the antenna coil 211 formed in a SIM holder 201 or an IC card holder 210 through the extra contact terminals CE1 and CE2. Those IC modules are preferable when the noncontact communication antenna terminals L1 and L2 of the three-way IC chip 203 are formed near the upper and the lower side, respectively, of the three-way IC chip 203.

Referring to Fig. 26(A), a contact-terminal plate 222 of an IC module in Example 3-3, similarly to that of the IC module in Example 3-2, has terminals C1 to C8 and extra contact terminals CE1 and CE2. Through holes 228 and 229 are formed in the extra contact terminals CE1 and CE2, respectively.

Fig. 26(B) is a view of the back surface of the contact-terminal plate 222 of the IC module in Example 3-3. Any antenna-terminal plates are not formed on the back surface of the contact-terminal plate 222. Circuits 241 and 242 for connecting the extra contact terminals CE1 and CE2 to the noncontact communication antenna terminals L1 and L2 of an IC chip 203 are formed on the back surface of the contact-terminal plate 222.

The through holes 228 and 229 of the extra contact terminals CE1 and CE2 are connected to the circuits 241 and 242. The extra contact terminals CE1 and CE2 are connected through the through holes 228 and 229 and the circuits 241 and 242 to the noncontact communication antenna terminals L1 and L2 of an IC chip 203 by bonding wires 227.

As shown in Fig. 26(B), the circuits 241 and 242 are formed in shapes resembling the letter U. The U-shaped circuits 241 and 242 are arranged opposite to each other so as to surround the IC chip 203.

Since different IC manufacturers manufacture IC chips differing from each other in the arrangement of the antenna terminals L1 and L2, the circuits 241 and 242 are formed so as to surround a region in which the IC chip 203 is placed to enable the antenna terminals L1 and L2 to be connected to the circuits 241 and 242 regardless of the arrangement thereof. Thus, the antenna terminals L1 and L2 can be connected by wires to the nearest parts of the circuits 241 and 242.

The circuits 241 and 242 can be formed by a generally known photolithographic process.

In the IC module 204 in Example 3-3, a SIM 202 or an IC card 220 is not provided with any antenna coil, and the IC module 204 is connected to the antenna coil 211 formed in a SIM holder 201 or an IC card holder 210 through the extra contact terminals CE1 and CE2. The IC module 204 is preferable when the positions of the antenna terminals L1 and L2 of the IC chip 203 are indefinite.

Fig. 27 is a view of a contact-terminal plate 222 of an IC module in Example 3-4. The contact-terminal plate 222 of the IC module in Example 3-4 is substantially the same as that of the IC module in Example 3-3. Whereas the noncontact communication antenna terminals L1 and L2 of the IC chip 203 of the IC module in Example 3-3 are formed near the lower side of the IC chip 203 as shown in Fig. 26(B), those of the IC chip 203 of the IC module in Example 3-4 are formed near the upper side of the IC chip 203 as shown in Fig. 27(B).

As shown in Fig. 27(B), plating leads 243 and 244 project from circuits 241 and 242. In a sheet consisting of a plurality of contact-terminal plates connected by small bridges, the plating leads 243 and 244 are continuous with those of the adjacent contact-terminal plates and are connected to a power source for plating. Similarly, the contact-terminal plates shown in Fig. 26 and those shown in Fig. 28 are provided with plating leads 243 and 244.

Fig. 28 is a view of a contact-terminal plate 222 of an IC module in Example 3-5. The contact-terminal plate 222 of the IC module in Example 3-5 is substantially the same as those of the IC modules in Examples 3-3 and 3-4. The contact-terminal plate 222 shown in Fig. 28 differs from those shown in Figs. 26 and 27 in that noncontact communication antenna terminals L1 and L2 of the IC chip 203 of the IC module in Example 3-5 are formed near middle parts of opposite sides of the IC chip 203 as shown in Fig. 28(B).

Since the U-shaped circuits 241 and 242 are formed on the back surface of the contact terminal plate of the IC module 204 so as to surround the IC chip 203, the antenna terminals L1 and L2 can be connected by wires to the nearest parts of the circuits 241 and 242 regardless of the arrangement thereof, and the contact terminal plate can be used in combination with various types of IC chips.

A three-way SIM and a three-way IC card according to the present invention will be described. Each of the three-way SIM and the three-way IC card is formed by mounting the aforesaid IC module of the present invention on a base card.

The three-way SIM (ID module) of the present invention is.the aforesaid SIM, UIM or USIM (hereinafter, "SIM" will be used as the general term for ID modules including UIMs and USIMs in the following description and claims) provided with an IC chip having contact, noncontact and USB contact functions, i.e., an IC chip provided with a triple interface.

The term "SIM" will be used as the general term for small ID modules of sizes corresponding to those of plug-in SIMs specified in GSM.1111 or 3GPPTS11.11. The function of the SIM is not limited to that of the aforesaid subscriber identification device for a portable telephone. Sometimes, the term "UIM" will be used instead of "SIM".

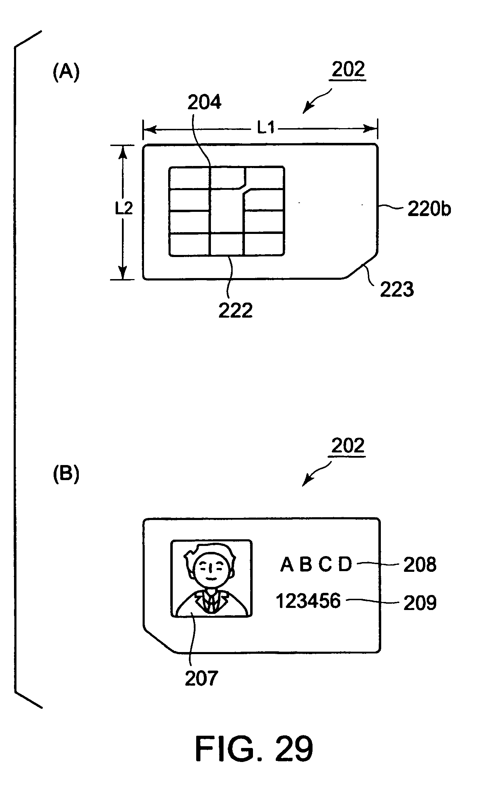

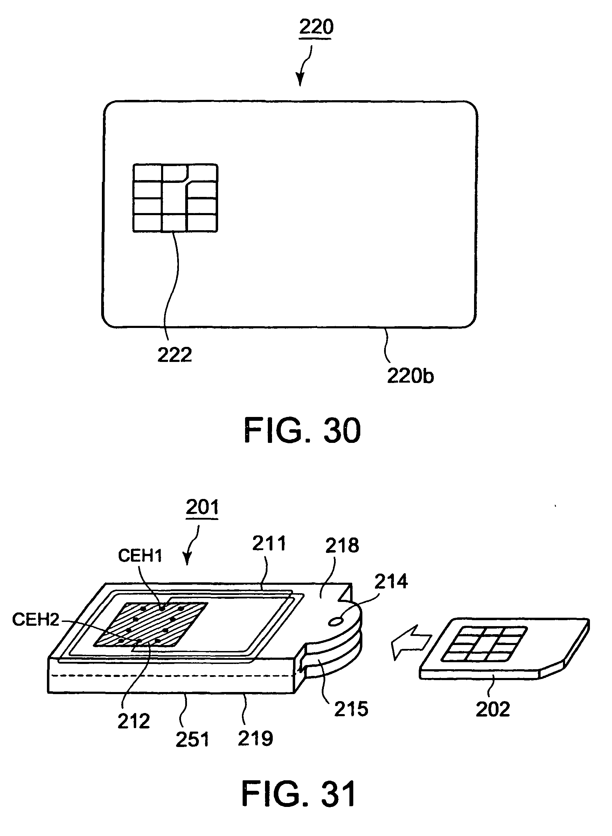

Fig. 29(A) is a plan view of the front surface of a three-way SIM 202 embodying the present invention, Fig. 29(B) is a plan view of the back surface of the three-way SIM 202, and Fig. 30 is a plan view of a three-way IC card 220. The three-way SIM 202 and the three-way IC card 220 employ any one of the IC modules in Examples 3-2 to 3-5.

Figs. 29, 30 and 45 show the SIM 202 and the IC card 220 provided with the IC module 204 in Example 3-1. The sizes and the arrangement of the contact terminals on the contact-terminal plate are determined in conformity with general IC card standards and the GSM (Global System for Mobile Communication).

The three-way SIM 202 has an IC module 204 and a SIM base 220b holding the IC module 204. An antenna coil 221 may be either embedded in or not embedded in the SIM base 220b. A SIM holder 201 must be provided with an antenna coil 211 to enable the SIM 202 to communicate with external devices through the antenna coil 211 of the SIM holder 201 when the SIM 202 is not provided with any antenna coil.

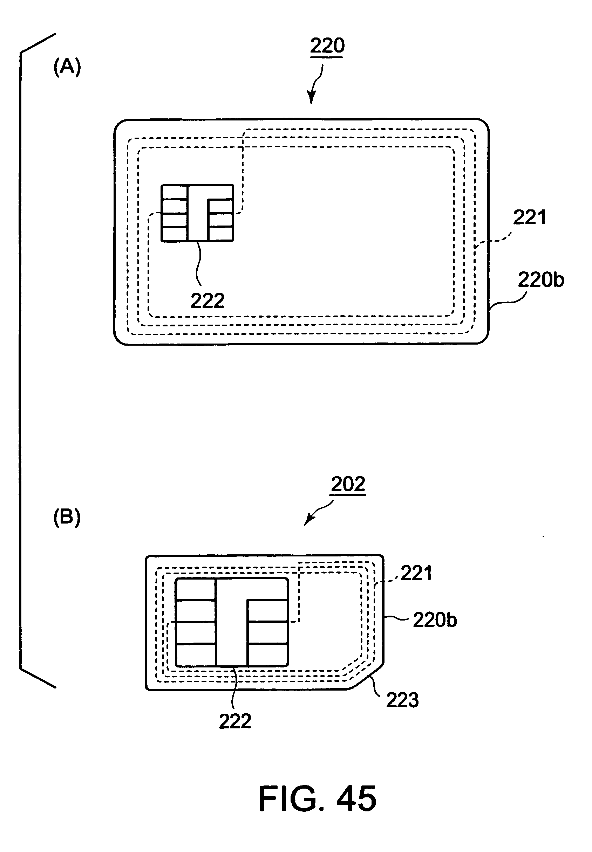

When one of the IC modules 204 in Example 3-2 to 3-5 is employed, the SIM 202 has the antenna coil 221 as shown in Fig. 45(B), and the antenna coil 221 is used for noncontact communication or the antenna coil 211 of the SIM holder 201 is used as an auxiliary coil for noncontact communication.

As shown in Fig. 29(A), the three-way SIM 202 has the shape of a thin rectangular plate having the long side L1 of about 25 mm, the short side L2 of about 15 mm, and the thickness of 1.0 mm or below (usually, 0.76 mm).

A bevel 223 is formed by cutting one of the corners of the rectangular three-way SIM 202 to facilitate the correct insertion of the three-way SIM 202 in the SIM holder 201.

The SIM base 220b, similarly to the IC card 220, is formed of a plastic material.

Any parts are not mounted on the back surface of the three-way SIM 202. As shown in Fig. 29(B), a half-length photograph 207, a name 208 and a number 209 may be printed on the back surface of the three-way SIM 202.

Although the half-length photograph 207, the name 208 and the number 209 are not essential, they facilitate the identification of the possessor. The half-length photograph 207, the name 208 and the number 209 may be formed by sublimation transfer printing, ink-jet printing or mechanical engraving.

Fig. 30 shows the three-way IC card 220 provided with one of the IC modules in Examples 3-2 to 3-5. Fig. 45(A) shows the three-way IC card 220 provided with the IC module in Example 3-1.

The three-way IC card 220 has a size specified in ISO 7816 (53.98 mm x 85.60 mm), which is large enough to form an effective antenna on the three-way IC card 220. When the IC module in Example 3-1 is employed, an antenna coil 221 is embedded in the SIM base 220b and is connected to the terminals of the contact-terminal plate 222 as shown in Fig. 45(A). Even if a SIM base 220b not provided with the antenna coil 221 is used, the three-way IC card 220 provided with one of the IC modules 204 in Examples 3-2 to 3-5 can be used for noncontact communication in combination with an IC card holder 210 provided with an antenna coil 211.

When the antenna coil 211 is formed in the SIM 202 or the SIM base 220b, the antenna coil 211 may be formed by winding a fine wire, etching a conductive film or printing a conductive line.

Generally, the antenna coil is formed by etching a metal film laminated to the SIM 202 or the core sheet (middle layer of the SIM base 220b) of the IC card 220. The antenna coil 221 formed in the SIM 202 or the SIM base 220b has six to ten complete turns of a conductive line. The opposite ends of the conductive line forming the antenna coil 221 are connected through antenna-terminal plates 224 and 225 on the back surface of the IC module 204 to the IC chip 203.

A SIM holder and an IC card holder.

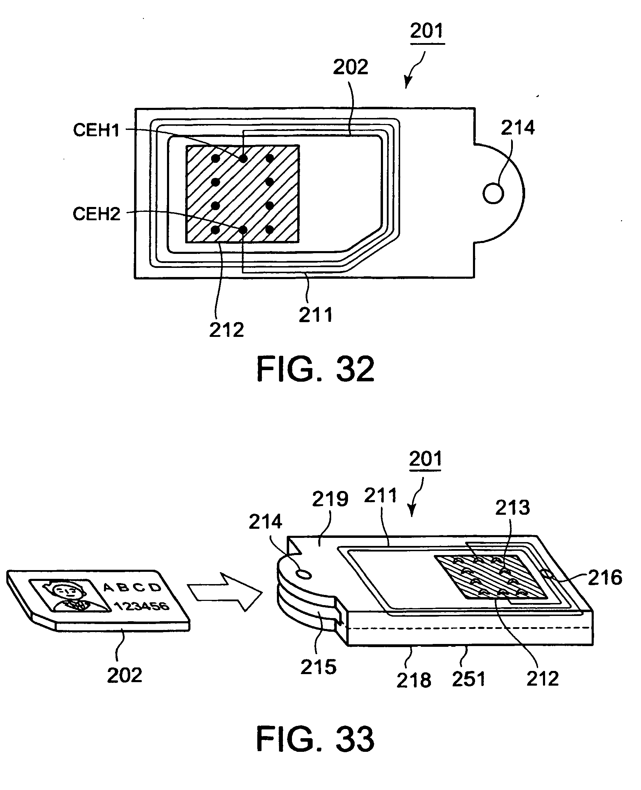

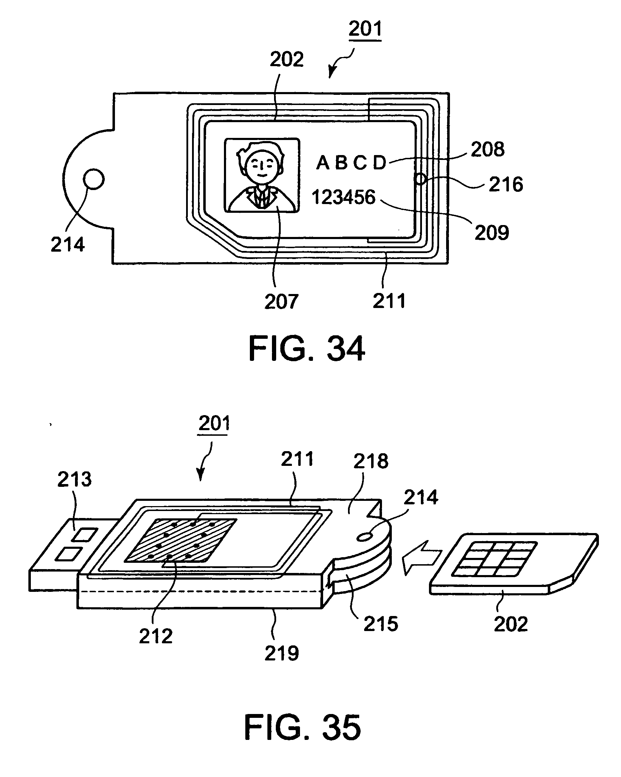

Fig. 31 is a perspective view of a SIM and a SIM holder 201, Fig. 32 is a top plan view of a SIM holder holding a SIM, Fig. 33 is a perspective view of a SIM and a SIM holder, and Fig. 34 is a bottom plan view of a. SIM holder holding a SIM.

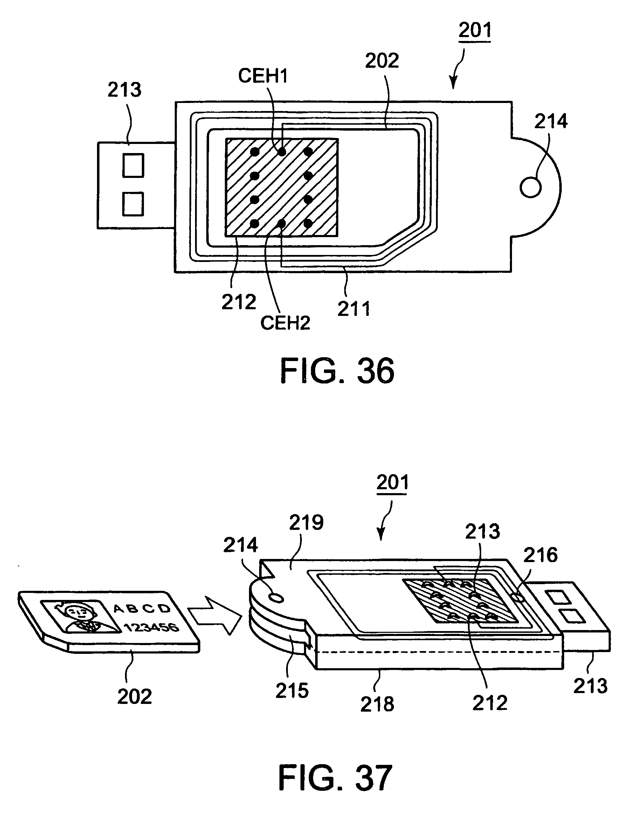

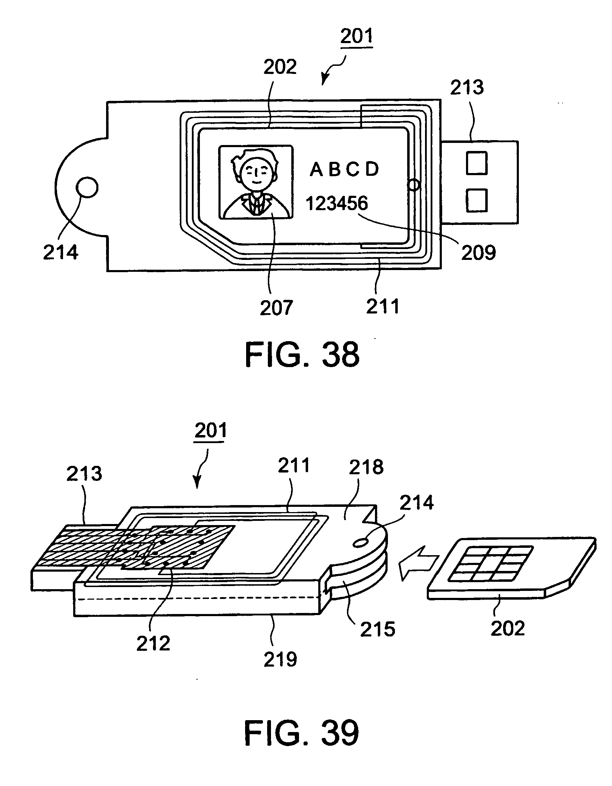

Fig. 35 is a front perspective view of a SIM holder in an example, and a SIM, Fig. 36 is a top plan view of a SIM holder in an example holding a SIM, Fig. 37 is a bottom plan view of a SIM holder in an example and a SIM, and Fig. 38 is a bottom plan view of a SIM holder en an example holding a SIM.

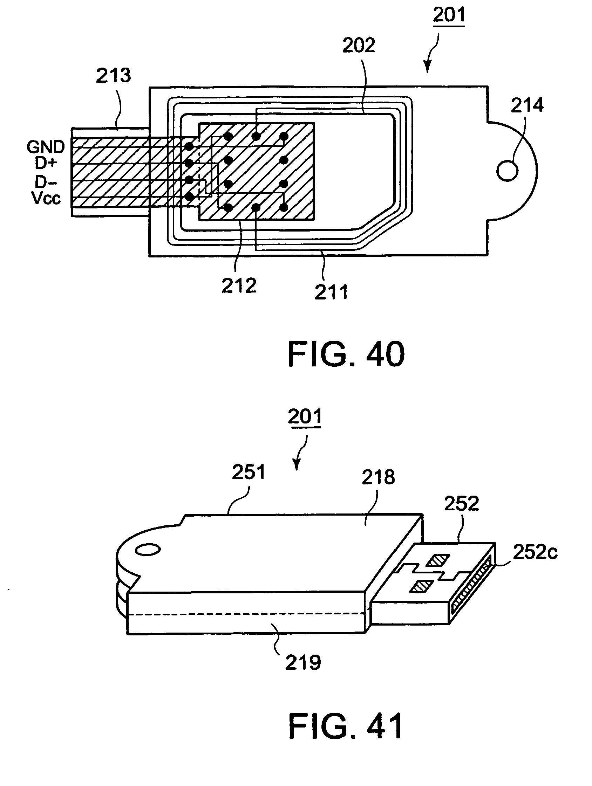

Fig. 39 is a perspective view of assistance in explaining the wiring relation between a terminal plate and a USB connector, Fig. 40 is a plan view of assistance in explaining the wiring relation between a SIM and the USB connector, Fig. 41 is a perspective view of a SIM holder, and Fig. 42 is a perspective view of an IC card holder.

Figs. 31 to 34 show SIM holders for noncontact communication not provided with any USB connector.

Referring to Fig. 31, a SIM holder 201 has a case 251, a SIM-connecting terminal plate 212 placed in the case 251, and an antenna coil 211 formed in the case 251. The antenna coil 211 is formed along the sides of the inner surface of the SIM holder 201. The antenna coil 211 is connected to pins CEH1 and CEH2 corresponding to terminals CE1 and CE2 of the terminal plate 212 provided with ten contact terminals.

A SIM 202 is held in the SIM holder 201 for radio communication.

When the SIM 202 is inserted through a slot 215 in the SIM holder 201, the SIM 202 is held fixedly under the terminal plate 212 in the SIM holder 201 by a locking device, not shown.

In this state, the terminals of the contact-terminal plate 222 of the SIM 202 are in contact with the corresponding contacts of the terminal plate 212 of the SIM holder 201. The antenna coil 211 is connected to the terminals corresponding to the terminals CE1 and CE2 of the contact-terminal plate 222.

Referring to Fig. 32 showing the SIM holder 201 holding the SIM 202 in a top plan view, the terminals of the contact-terminal plate 222 of the SIM 202 are in contact with the corresponding terminals formed on the back surface of the terminal plate 212 of the SIM holder 201. The terminals CEH1 and CEH2 of the SIM holder 201 correspond to the terminals CE1 and CE2 of the contact-terminal plate 222 of the SIM 202.

In Figs. 31 and 32, the SIM holder 201 is transparent to facilitate understanding. Actually, the SIM holder 201 is formed of an opaque resin to conceal the antenna coil 211 and the terminal plate 212.

Fig. 33 is a back perspective view of the SIM and the SIM holder, and Fig. 34 is a bottom plan view of the SIM holder holding the SIM.

As shown in Fig. 33, the terminal plate 212 is provided with ten contact pins. The antenna coil 211 is connected to the contact pins of the terminal plate 212 corresponding to the terminals CE1 and CE2. The SIM 202 can be released from the locking device by inserting the tip of a ballpoint pen in a small hole 216.

A half-length photograph 207, a name 208 and a number 209 are printed on SIM 202. The SIM holder 201 is entirely transparent or a part thereof corresponding to the surface of the SIM 201 provided with the half-length photograph 207, the name 208 and the number 209 is transparent to enable the visual recognition of the half-length photograph 207, the name 208 and the number 209.

Figs. 35 to 38 show a SIM holder provided with a USB connector for noncontact communication and USB contact communication.

Figs. 35 and 36 are a front perspective view and a top plan view, respectively, of a SIM holder 201 holding a SIM 202. The SIM holder 201 shown in Fig. 35 is provided with a USB connector 213 in addition to the components of the SIM connector 201 shown in Fig. 31 showing the connection of ten contact terminals to be connected to the corresponding terminals of a contact-terminal plate included in the SIM 202, and terminals CE1 and CE2.

The SIM holder 201 shown in Fig. 36 has, similarly to the SIM holder 201 shown in Fig. 32, terminals CEH1 and CEH2 respectively corresponding to the terminals CE1 and CE2 of the contact-terminal plate 222 of the SIM 202

Figs. 37 and 38 are a back perspective view and a plan view, respectively, of the SIM holder 201 and the SIM 202.

Figs. 39 and 40 are a perspective view and a plan view, respectively, of assistance in explaining the wiring relation between the terminal plate 212 and the USB connector 213. As shown in Figs. 39 and 40, the terminals C5, C1, C4 and C8 of the SIM 202 are connected to GND, V_{cc}, D+ of USB and D- of USB, respectively, by USB connector lines of the USB connector 213. Thus, the SIM 202 is able to exchange D+ and D- signals with a PC by using a protocol defined by the USB standards.

It has been usual to connect a conventional SIM or a conventional IC card to a USB connector through an interface-converting IC chip capable of changing a protocol and a format. The recently developed IC chip provided with a USB contact interface makes it possible to omit the interface-converting IC chip.

Data transmission rate based on the USB standards is 12 Mb/s, which is far higher than data transfer rate of 38 kb/s at which data is transferred through an I/O pad using a protocol and a format defined by ISO 7816.

Figs. 41 and 42 are perspective views of a SIM holder and an IC card holder, respectively.

The SIM holder 201 has a case 151 formed by molding a plastic material, and a metal plug 152 attached to the case 151. The plug 152 defines an opening 152c, and the terminals GND, V_{cc}, D+ and D- are arranged in the opening 152c. The plug 152 is inserted in a receptacle formed in a PC for data communication.

The IC card holder 210 is similar in construction to the SIM holder 201. The IC card holder 210 does not need to receive the IC card 220 entirely therein; the IC card holder 210 may be able to hold the IC card 220 partly such that the contact-terminal plate 222 of the IC card 220 is in contact with the terminal plate 212 of the IC card holder 210 as shown in Fig. 42. In Fig. 42, the IC card holder 210 has a case 210a formed by joining an upper case 218 and a lower case 219, and a part of the IC card 220 is held between the upper case 218 and the lower case 219. The terminal plate 212 is attached to the upper case 218.

Naturally, the IC card holder 210 may be formed so as to accommodate the IC card 220 entirely therein.

Since a comparatively large antenna can be formed on the base card 220b of the IC card 220, it is not essential to form an antenna coil on the IC card holder 210. However, the IC card holder 210 can be used for noncontact communication and USB connection by using an IC card 220 not provided with any antenna, when the IC card holder 210 is provided with the antenna coil 211.

Plastic materials suitable for forming the case 251 of the SIM holder 201, and the case 210a of the IC card holder 210 by molding include acrylic resins, polycarbonate resins, polyolefin resins including polypropylene resins and polyethylene resins, polystyrene resins, polyester resins and polyvinyl chloride resins.

When the SIM holder 201 is formed in a thickness of 10 mm or below, a width of 25 mm or below and a length of 50 mm or below, the SIM holder 201 is small and easy to carry.

A method of using the three-way SIM 202 and the SIM holder 201, or the three-way IC card 220 and the IC card holder 210 will be described.

The three-way SIM 202 and the three-way IC card 220 of the present invention can be issued similarly to the conventional IC cards after writing data for identifying the possessor thereto. The three-way SIM 202 of the present invention can be manufactured and issued by the conventional IC card manufacturing and issuing method that that forms a sheet consisting of a plurality of wallet-sized SIMs connected by small bridges, and cuts the bridges to separate the SIMs.

The three-way SIM 202 of the present invention held in the SIM holder 201 functions as a noncontact ID module in a noncontact magnetic field, and is able to function for noncontact communication with external devices, such as door locks and ticket gates. The functions of the three-way IC card 220 are the same as those of the three-way SIM 202.

When the USB connector of the SIM holder 201 holding the SIM 202 is connected to the USB connector of a PC, the SIM 202 functions as a USB interface ID module. Thus, only authenticated persons are able to access a network to exclude unauthenticated persons from accessing the network. When the SIM holder 201 holding the SIM 202 is used, an IC card reader/writer necessary for using conventional IC cards is unnecessary.

The contact communication function of the three-way SIM 202 or the three-way IC card 220 is used by an issuing process for issuing the three-way SIM 202 or the three-way IC card 220. The three-way SIM 202 can be used as an ID module for a portable telephone for data exchange between the portable telephone and a contact terminal.

The three-way SIM 202 held in the SIM holder 201 connected to a portable telephone by a strap is extracted from the SIM holder 201 and can be used as the SIM 202 of the portable telephone.

It goes without saying that the three-way IC card can be used as a contact terminal, such as a credit card or a cash card.

The IC module of the present invention provided with the three interfaces has the antenna-terminal plate to be connected to the antenna coil formed in the base, or the extra contact terminals to be connected to the antenna formed in the holder, and the USB connector. The IC module of the present invention is capable of contact communication, noncontact communication and USB contact communication. It is obvious that the three-way SIM and the three-way IC module of the present invention capable of communicating with external devices in three communication modes, namely, a contact communication mode, a noncontact communication mode and a USB contact communication mode can be used in an extensive field wider than that in which the conventional two-way card capable of communicating with external devices for contact communication and noncontact communication or for contact communication and USB contact communication can be used.

Whereas the conventional ID module is provided with a USB interface and a microcomputer, the present invention provides the combination of the SIM holder and the SIM, or the combination of the IC card and the IC card holder, forms the ID module by holding the three-way SIM in the SIM holder, forms the antenna coil in the IM holder or the IC card holder to form the USB ID module, to use the ID module as a noncontact ID module for operating door locks and ticket gates.

The SIM has an advantage of enabling a personalizing issuing process that is performed before the bridged SIMs are separated into wallet-sized IC cards.

The half-length photograph, the name and the number can be printed on the surface of the SIM behind the terminals, an ID module having the shape of a small SIM can be formed, and the SIM holder formed of a transparent plastic material enables the visual recognition of the half-length photograph formed on the SIM held in the SIM holder.

### Second Embodiment

An IC module in a second embodiment according to the present invention will be described.

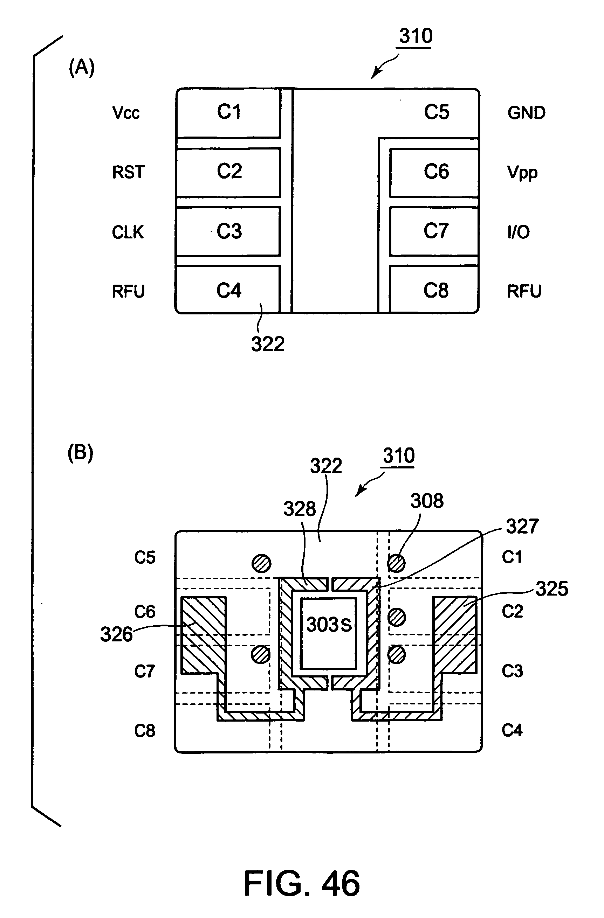

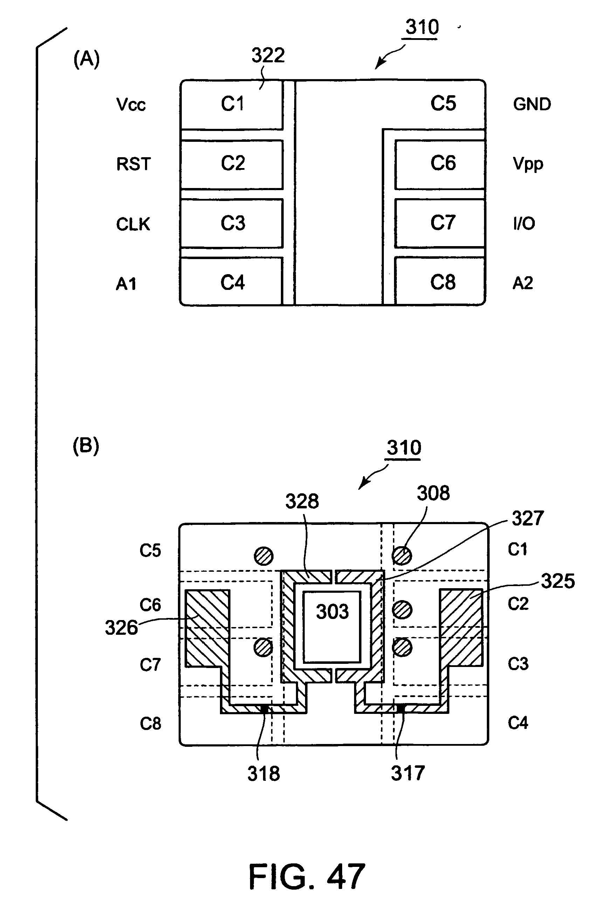

Fig. 46 is a view of an IC module (sometimes, referred to as "IC module board") in Example 4-1 not covered by the claims and Fig. 47 is a view of an IC module in Example 4-2 not covered by the claims.

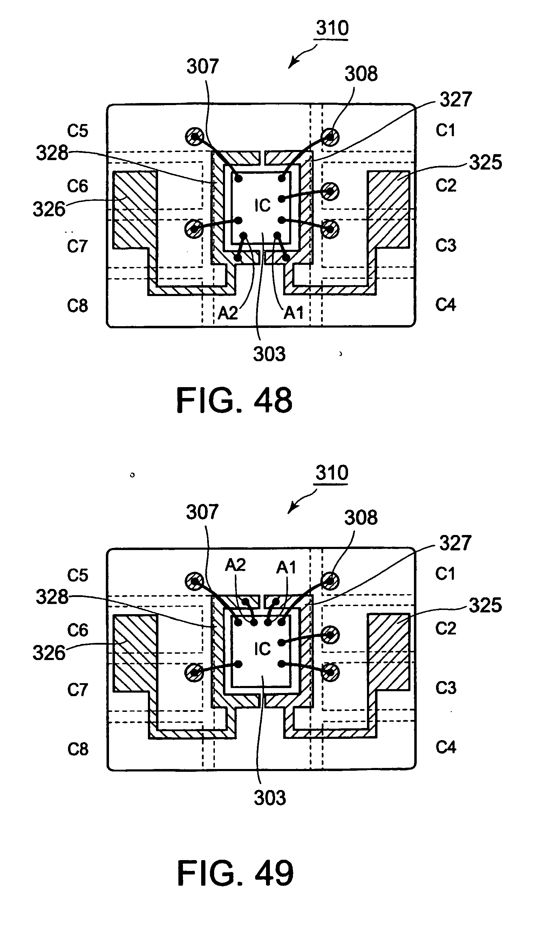

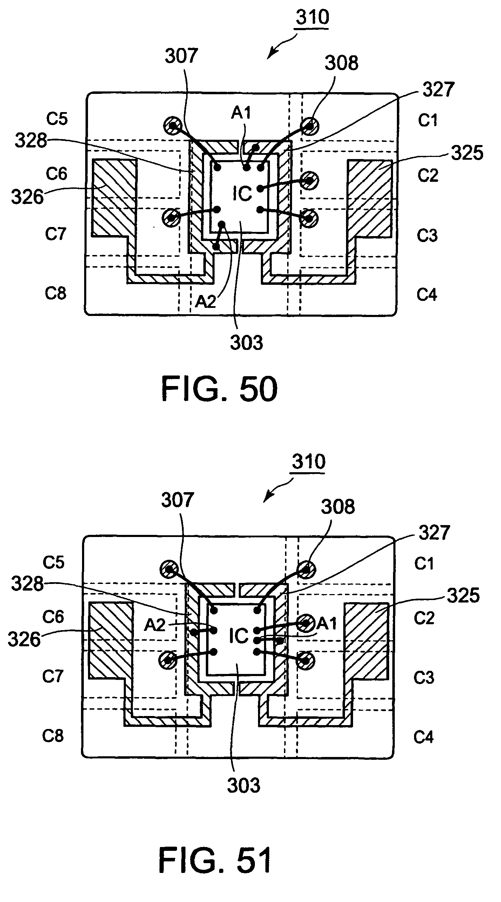

Fig. 48 is a view of an IC module provided with an IC chip mounted on a substrate and having antenna pads formed near the lower side thereof, Fig. 49 is a view of an IC module provided with an IC chip mounted on a substrate and having antenna pads formed near the upper side thereof, Fig. 50 is a view of an IC module provided with an IC chip mounted on a substrate and having antenna pads formed on the upper and the lower side, respectively, and Fig. 51 is a view of an IC module provided with an IC chip mounted on a substrate and having antenna pads formed at middle parts of the right and left sides thereof.

An IC module 310 has a substrate 310a, a contact-terminal plate 322 mounted on the substrate 310a, and an IC chip 303 mounted on the substrate 310a. The IC chip 303 is connected electrically to the contact-terminal plate 322 by wires 307.

As shown in Fig. 46, an IC module 310 in Example 4-1 is provided on its front surface with terminals C1 to C8 arranged in conformity to ISO 7816. The terminals C1, C2, C3, C5, C6 and C7 are a V_{cc} terminal, a RST terminal, a CLK terminal, a GND terminal, a Vₚₚ terminal and an I/O terminal, respectively. The terminals C4 and C8 are RFU (reserved-for-future-use) terminals, which are not used.

Parts of a metal film corresponding to grooves between the adjacent terminals in Fig. 46(A) are removed by etching to form nonconductive parts.

As shown in Fig. 46(B), antenna-terminal plates 325 and 326 are formed in parts of the back surface of the IC module 310 corresponding to the terminals C2 and C3 and corresponding to the terminals C6 and C7, respectively.

The antenna-terminal plates 325 and 326 are electrically connected to antenna coils 311 and 321 formed in the bases 305a and 306b of an IC card 305 or a SIM 306. The antenna-terminal plates 325 and 326 are connected to the terminals of a noncontact communication part of the IC chip 303 by bonding wires 307.

The IC module 310 is featured by U-shaped circuits 327 and 328 formed opposite to each other on the back surface of the substrate 310a so as to surround the IC chip 303S. The U-shaped circuits 327 and 328 are connected electrically to the antenna-terminal plates 325 and 226, respectively.

As shown in Fig. 47, an IC module 310 in Example 4-2 is provided on its front surface with terminals C1 to C8 arranged in conformity to ISO 7816. The terminals C1, C2, C3, C5, C6 and C7 are a V_{cc} terminal, a RST terminal, a CLK terminal, a GND terminal, a Vₚₚ terminal and an I/O terminal, respectively. The terminals C4 and C8 can be used as antenna terminals A1 and A2 instead of RFU terminals.

The antenna terminals (pads) A1 and A2 of the IC chip 303 are connected through a terminal plate placed in an IC card holder to an antenna coil formed in the IC card holder.

As shown in Fig. 47 (B), antenna-terminal plates 325 and 326 are formed, similarly to the antenna-terminal plates 235 and 236 of the IC module 310 in Example 4-1, in parts of the back surface of the IC module 310. The IC module 310 in Example 4-2 is provided with U-shaped circuits 327 and 328 arranged opposite to each other so as to surround the IC chip 303. The U-shaped circuits 327 and 328 are connected electrically to the antenna-terminal plates 325 and 226, respectively.

As shown in Fig. 47, the IC module 310 is provided with through holes 317 and 318. The antenna terminals A1 and A2 are connected through the through holes 317 and 318 to the U-shaped circuits 327 and 328, respectively.

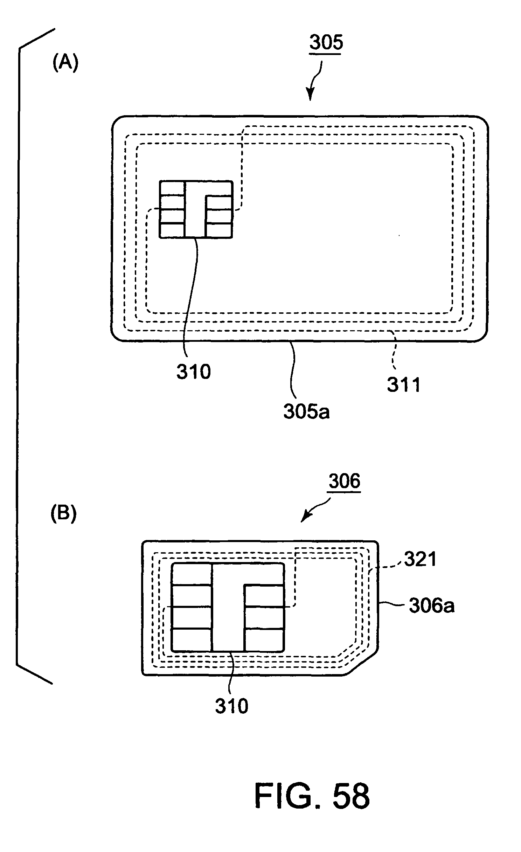

This IC module 310 is suitable for use when an IC card 305 is provided with an antenna coil 311 or a SIM 306 is provided with an antenna coil 321, and the terminals Cr and C8 are connected to the antenna of a SIM holder holding the SIM 306 or the antenna of an IC card holder holding an IC card 305 (Fig. 58).

The IC module 310 provided with the IC chip 303 will be described. Figs. 48 to 51 show the IC module 310 in Example 4-1 or 4-2 provided with an IC chip 303 having terminals connected to pads 308 by bonding wires 307.

The IC modules 310 in Examples 4-1 and 4-2 are the same in construction, except that the IC module 310 in Example 4-2 is provided with the through holes 317 and 318. In Figs. 48 to 51 the through holes 317 and 318 are omitted.

Fig. 48 shows the IC module 310 provided with an IC chip 303 connected to the IC module 310 by bonding wires 307 and having antenna terminals A1 and A2 formed near the lower side thereof.

The U-shaped circuits 327 and 328 are connected to the antenna terminals A1 and A2 by wires, respectively. The pads 308 connected to the terminals C1, C2, C3, C5 and C7 are connected.to the terminals of the IC chip 303 by wires 307.

The components of the wiring excluding the antenna-terminal plates 325 and 326 are coated with a resin coat formed by molding. Fig. 48 is a view taken through the resin coat.

Fig. 49 shows the IC module 310 provided with an IC chip 303 connected to the pads 308 of the IC module 310 by bonding wires 307. The IC chip 303 has antenna terminals A1 and A2 formed near the upper side thereof.

The IC module 310 shown in Fig. 50 is similar to that shown in Fig. 49. The IC module 310 is provided with an IC chip 303 having antenna terminals A1 and A2 near the upper and the lower side thereof, respectively.

Fig. 51 shows the IC module 310 provided with an IC chip 303 having antenna terminals A1 and A2 formed near middle parts of the right and the left side thereof, respectively.

Thus, the IC module 310 of the present invention is provided with the U-shaped circuits 327 and 328 formed so as to surround the IC chip 303. Therefore, the antenna terminals A1 and A2 of the IC chip 303 can be connected to the IC module 310 by short wires regardless of the positions of the antenna terminals A1 and A2.

An IC module using an IC chip provided with contact, noncontact and USB contact interfaces will be described.

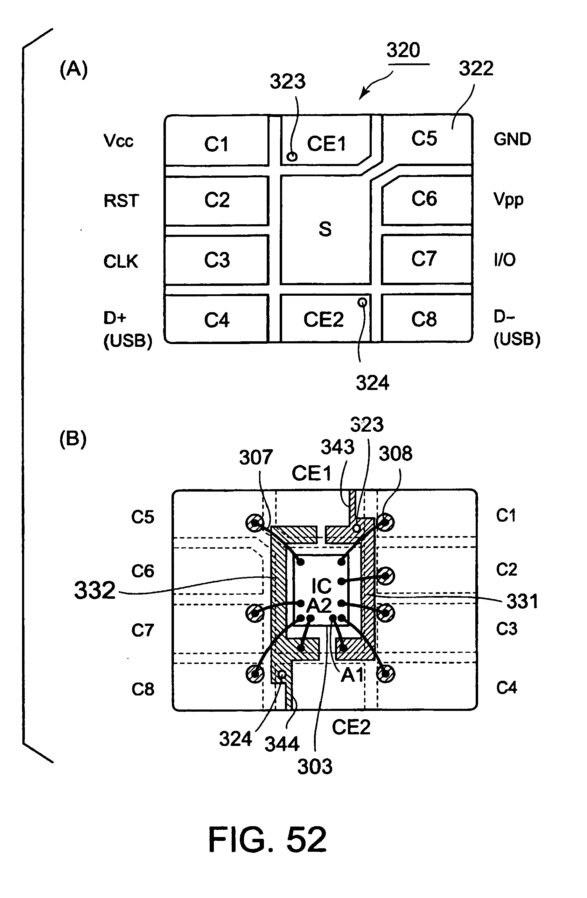

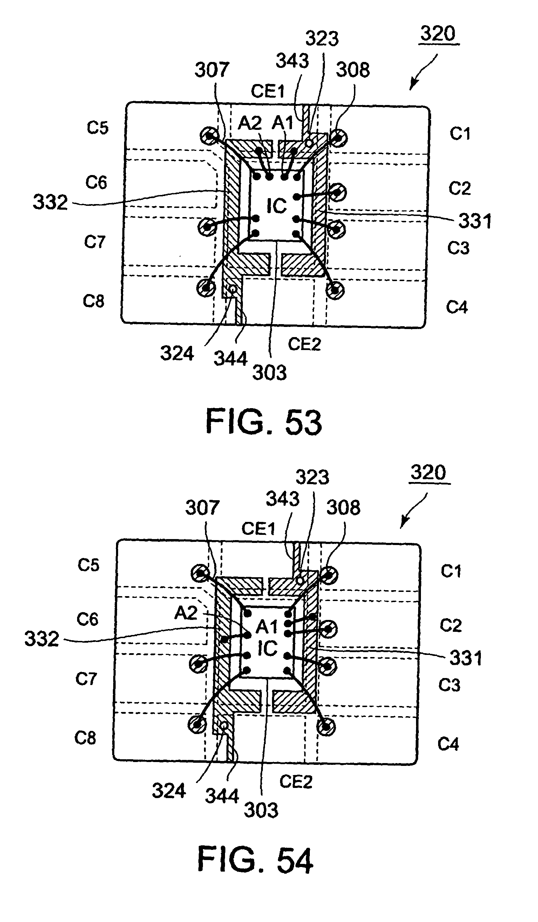

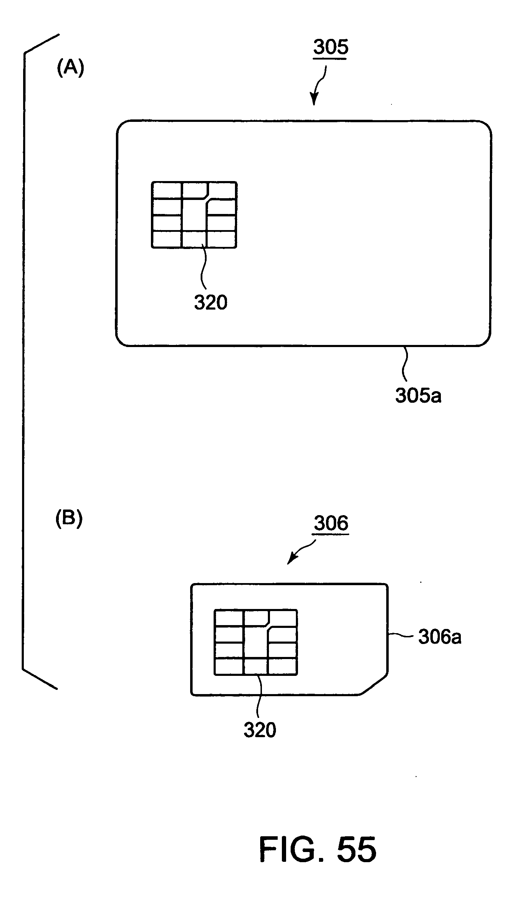

Fig. 52 (A) (B) are views of an IC module 320 in Example 4-3, Figs. 53 and 54 are views of the IC module 320 in Example 4-3 provided with an IC chip 303 and Fig. 55 is a plan view of an IC card provided with three types of interfaces, and a SIM.

The IC chip 303 of Example 4-3 includes a contact interface conforming to ISO 7816-2 and ISO 7816-3, a noncontact interface conforming to ISO 1443 and a USB contact interface.

It is preferable to use this IC module 320 when a SIM 306 or an IC card 305 is not provided with any antenna coil, and an antenna formed in a SIM holder or an IC card holder is used.

A contact terminal plate 322 in Example 4-3 is provided with terminals C1 to C8 as V_{cc}, RST, CLK D+ for USB, GND, Vₚₚ, I/O and D- for USB, respectively.

The terminal C5, i.e., a GND terminal, is connected to a central region S to form the terminal C5 in a large area. The terminal C5 does not need necessarily to be connected to the central region S. Practically, the terminal C6, i.e., the Vₚₚ terminal (variable supply voltage terminal) is not used.

The IC module 320 in Example 4-3 is featured by extra contact terminals CE1 and CE2 disposed between the terminals C1 and C5 and between the terminals C4 and C8, respectively, on the contact-terminal plate 322.

Fig. 52(B) shows the back surface of the IC module 320 in Example 4-3.

U-shaped circuits 331 and 332 are formed opposite to each other on the back surface of the contact-terminal plate 322 so as to be separated from each other and to surround the IC chip 303.

The extra contact terminals CE1 and CE2 are connected electrically through through holes 323 and 324 to the U-shaped circuits 331 and 332, respectively. Naturally, the extra contact terminals CE1 and CE2 may be connected to pads formed on a substrate by wires.

As shown in Fig. 52(B), plating leads 343 and 344 project from U-shaped circuits 341 and 342. In a sheet consisting of a plurality of contact-terminal plates connected by small bridges, the plating leads 343 and 344 are continuous with those of the adjacent contact-terminal plates and are connected to a power source for plating. Similarly, the contact-terminal plates shown in Figs. 53 and 54 are provided with plating leads.

The terminals C1, C2, C3, C5, C6 and C7 connected to pads 308, similarly to those of the IC module 310 in Example 4-1 or 4-2, are connected to the terminals of the IC chip 303 by wires 307. The terminals C4 (D+ terminal for USB) and the terminal C8 (D- terminal for USB) are connected to the USB contact interface of the IC chip 303.

In Fig. 52(B), the antenna terminals A1 and A2 are formed near the lower side of the IC chip 303, and are connected to the U-shaped circuits 331 and 332 by bonding wires 307, respectively.

In Fig. 53 showing an IC chip 303 mounted on and electrically connected by bonding wires 307 to the IC module 320, the antenna terminals A1 and A2 are formed near the upper side of the IC chip 303, and are connected to the U-shaped circuits 331 and 332 by bonding wires 307, respectively.

In Fig. 54, the antenna terminals A1 and A2 are formed near middle parts of the right and the left side of the IC chip 303, and are connected to the U-shaped circuits 331 and 332 by bonding wires 307, respectively.

The antenna terminals A1 and A2 may be formed near the upper and the lower side of the IC chip 303.

Fig. 55 shows an IC card 305 and a SIM 306 provided with the IC module 320 in Example 4-3 having the substrate of the foregoing configuration.

Fig. 55(A) shows the three-way IC card 305, and Fig. 55(B) shows the three-way SIM 306.

As a general rule, the bases 305a and 306a of the three-way IC card 305 and the three-way SIM 306 are not provided with any antenna coils. The IC card 305 and the SIM 306 are connected through the contact-terminal plate 322 to the antennas of an IC card holder and a SIM holder, respectively.

As mentioned above, the IC modules 310 and 320 can preferably be used in combination with any one of the IC chips 303 provided with the antenna terminals A1 and A2 and when the positions of the antenna terminals A1 and A2 of the IC chip 303 are indefinite.

Although different IC manufacturers manufacture IC chips differing from each other in the arrangement of the antenna terminals A1 and A2, the antenna terminals A1 and A2 can be connected through the U-shaped circuits 327 and 328 or the U-shaped circuits 331 and 332 to the IC module 310 or 322 regardless of the arrangement thereof.

The IC module 310 (320) of the present invention has a substrate 310a formed by laminating copper foils of about 35 µm in thickness to the opposite surfaces of an insulating substrate of about 100 µm in thickness formed of a glass-fiber-reinforced epoxy resin, a melamine resin or a polyimide resin, and subjecting the substrate coated with the copper foils to a generally known photolithographic process to form the terminals and the circuits. The surfaces of lines formed by processing the copper foils by the photolithographic process may be coated with a nickel film of about 5 µm in thickness by nickel plating, and the surfaces of the nickel plated lines may further be coated with a 0.5 µm thick gold film by gold plating to enhance the conductivity and durability of the lines.

Since the IC module of the present invention is provided with the U-shaped circuits formed opposite to each other on the back surface of the contact-terminal plate so as to surround a region in which the IC chip is to be placed, the terminals for noncontact communication of the IC chip can be connected to the U-shaped circuits by short bonding wires regardless of the positions of the terminals.

The three-way IC module of the present invention capable of communicating with external devices in three communication modes, namely, a contact communication mode, a noncontact communication mode and a USB contact communication mode, has the terminal plate of the same size and the same terminal arrangement as those of the conventional IC module.

### Further Example not covered by the claims

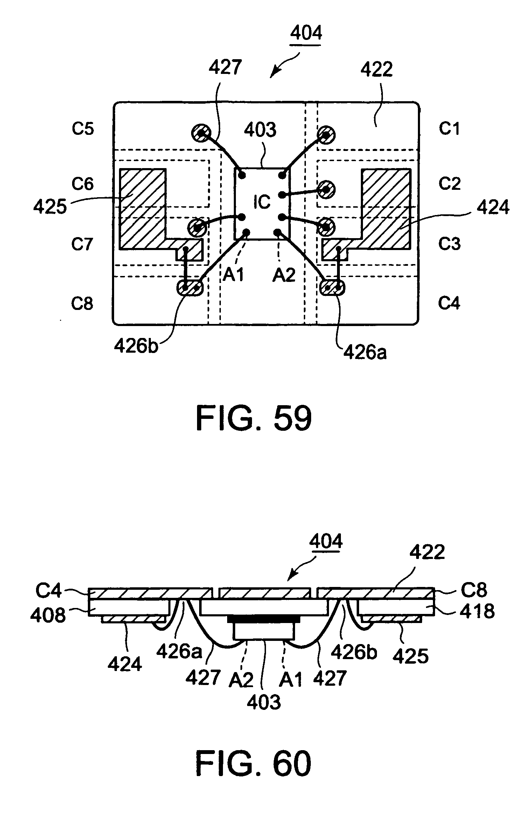

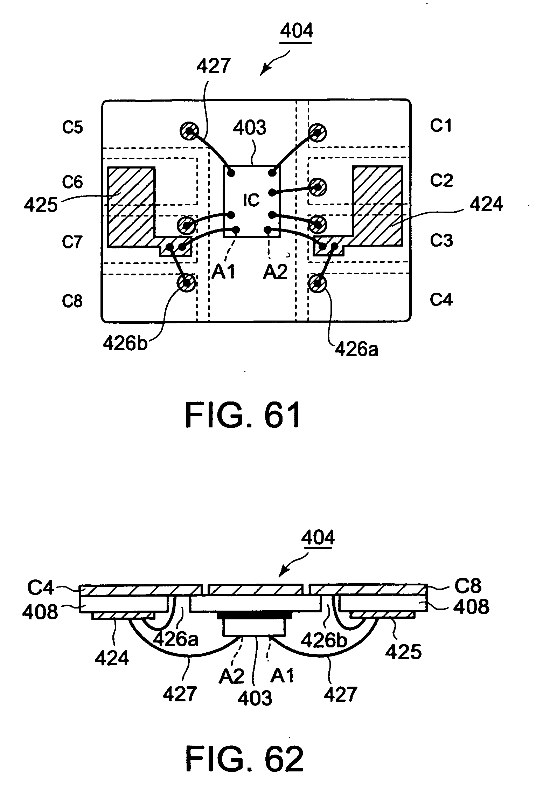

Fig. 59 is a back view of an IC module in Example 5-1 not covered by the claims, Fig. 60 is a sectional view of a noncontact interface included in the IC module shown in Fig. 59, Fig. 61 is a back view of an IC module in Example 5-2 not covered by the claims for an IC card, and Fig. 62 is a sectional view of the noncontact interface connected to an IC chip.

Referring to Figs. 59 and 60, an IC module 404 in Example 5-1 has a substrate 408, a contact-terminal plate 422 mounted on the substrate 408, and an IC chip 403 mounted on the substrate 408. Through holes are formed in parts of the substrate 408 corresponding to terminals C4 and C8 formed on the contact-terminal plate 422, and pads 426a and 426b are formed on the back surface of the terminals C4 and C8 corresponding to the through holes of the substrate 408. The pad 426a of the terminal C4 is connected to an antenna-terminal plate 424 by a wire 427 by wire bonding and connected by wire bonding to a pad A2 formed on the IC chip 403. The pad 426b of the terminal C8 is connected by wire bonding to an antenna-terminal plate 425 and connected by wire bonding to a pad A1 formed on the IC chip 403.

An IC module 404 in Example 5-2 is similar to the IC module 404 in Example 5-1. In the IC module in Example 5-2, pads 426a and 426b formed on the back surface of terminals C4 and C8, respectively, as shown in Figs. 61 and 62.

The pad 426a is connected to an antenna-terminal plate 424 by wire bonding, and the antenna-terminal plate 424 is connected by wire bonding to a pad A2 formed on an IC chip 303. The pad 426b is connected by wire bonding to an antenna-terminal plate 425, and the antenna-terminal plate 425 is connected by wire bonding to a pad A1 formed on the IC chip 403.

The wire-bonded parts, the pads and the IC chips 403 of the IC modules 404 in Examples 5-1 and 5-2 are coated with a resin coat by molding after the wiring has been completed.

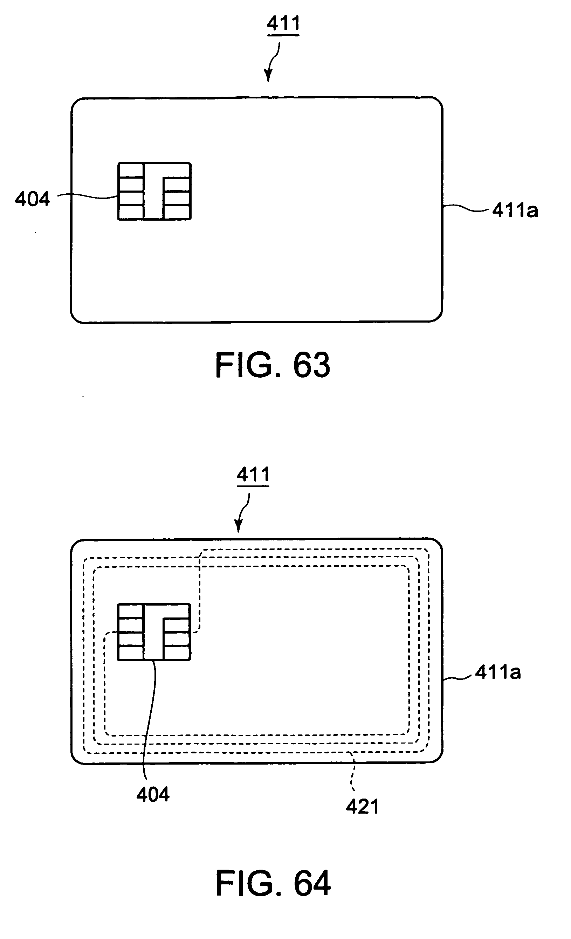

The antenna-terminal plates 424 and 425 of the IC module 404 of the present invention can directly be connected to an antenna coil 421 formed in the base 411a of an IC card 411. Thus, the IC card 411 can be used in both a contact communication mode and a noncontact communication mode (Fig. 64).

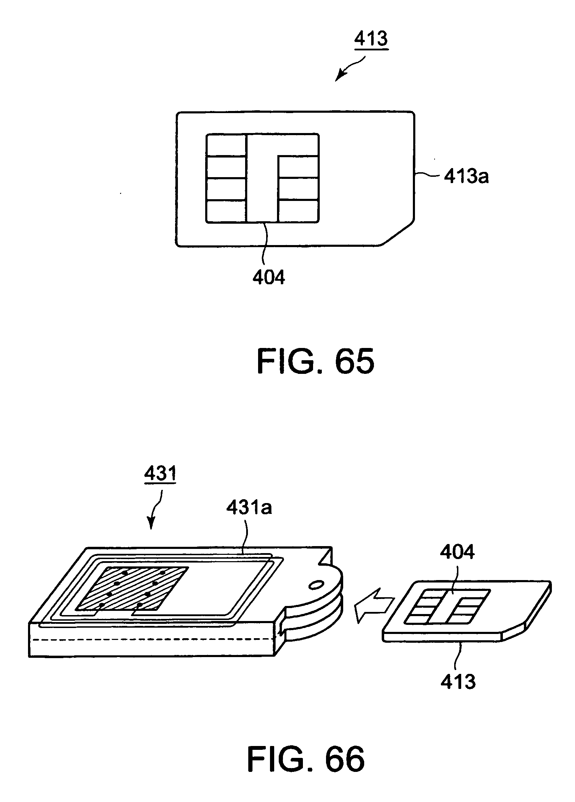

When the IC module 404 is incorporated into a SIM 413 having a base 413a to use an antenna 431a of a portable telephone or a SIM (UIM) holder 431, the antenna 431a is connected through the terminals C4 and C8 of the contact-terminal plate 422 to the noncontact interface of the IC chip 403 (Figs. 65 and 66).

Thus the IC module 404 provided with the dual interface IC chip 403 can be used for various purposes.

In fabricating the IC module 404, the insulated substrate (printed wiring board) 408 is formed. The through holes are formed in parts of the insulating substrate 408 corresponding to the pads 426a and 426b. The insulating substrate 408 is a laminated sheet formed by bonding together a resin film, such as a glass-fiber-reinforced epoxy resin film, a polyester film, a polyimide film or a bismaleimide-triazine resin film, of a thickness in the range of about 75 to about 100 µm, and a thermosetting adhesive sheet.

After forming the through holes in predetermined parts of the insulating substrate 408, copper foils are bonded to the opposite surfaces of the substrate 408 by hot pressing. Then, the substrate 408 is subjected to an ordinary photolithographic process to form the terminals C1 to C8 on the front surface of the substrate 408 and to form the antenna-terminal plates 424 and 425 on the back surface of the substrate 408. The thickness of the copper foil is in the range of about 18 to about 25 µm.

A resist film used by the photolithographic process is removed, and the terminals C1 to C8 and the antenna-terminal plates 424 and 425 are subjected to a nickel plating process and a gold plating process.

The dual interface IC chip 403 is bonded to the substrate 408 with an epoxy adhesive, and the terminals of the IC chip 403 are connected to the corresponding pads 426 of the substrate 408 by wires 427 by wire bonding.

Then, the IC chip 403 and the bonding wires 427 are coated with a resin coat by a transfer molding process, a casting process or the like, and, when necessary, the back surface is ground to complete the IC module 404 of a desired thickness.

In the foregoing embodiments, it is possible to use through holes instead of the pads formed on the substrate for the terminals. However, the following problems arise when through holes are used instead of the pads.
(1) Manufacturing processes are complicated and manufacturing cost increases.
(2) The resin seeps through the through holes onto the front surface of the substrate when the resin is used to seal the components of the IC module, which is liable to cause faulty electrical connection and reduces yield and reliability.

Information relating to the manufacturing method is mentioned in Jpn. Pat. No. 2904785.

As apparent from the foregoing description, the IC module of the present invention for the IC card can be used for forming both an IC card for contact and noncontact communication, and a SIM (UIM) to be used in combination with a SIM holder provided with an antenna.

## Claims

1. An IC module (204), comprising:
- a substrate (204a);
- an IC chip (203) mounted on the substrate (204a); and
- a contact-terminal plate (222) having a plurality of contact terminals (C1 - C8, CE1, CE2); and
said IC chip (203) and said contact terminal plate (222) are mounted on the substrate (204a); wherein
the plurality of contact terminals includes terminals C1 - C8 (C1- C8) conforming to ISO 7816 standard and said terminals C1 - C8 (C1 - C8) are referred to C1 - C8 in the ISO 7816 standard; and
said IC module includes extra contact terminals called CE1 and CE2 in the following (CE1, CE2) connected to antenna terminals (L1, L2) of the IC chip (203), wherein said extra contact terminals CE1, CE2 (CE1, CE2) of the contact terminal plate (222) are adapted to be connected to antenna terminals of an antenna coil,
said IC module being **characterized in that**
a pair of U-shaped circuits (241, 242) are formed so as to surround the IC chip (203) on a surface of the substrate (204a) opposite a surface of the substrate (204a) on which the contact terminal plate (222) is mounted, the extra contact terminals CE1 and CE2 (CE1, CE2) are connected to the U-shaped circuits (241, 242), respectively, and the U-shaped circuits (241, 242) are connected to the antenna terminals (L1, L2) of the IC chip (203), respectively.

2. The IC module (204) according to claim 1, wherein said extra contact terminal CE1 (CE1) is disposed between said terminal C1 (C1) and said terminal C5 (C5) among said eight contact terminals C1 - C8 (C1 - C8), and said extra contact terminal CE2 (CE2) is disposed between said terminals C4 (C4) and C8 (C8) among said eight contact terminals C1 - C8 (C1 - C8).

3. The IC module (204) according one of the preceding claims, wherein the extra contact terminals CE1 (CE1) and CE2 (CE2) are those to be connected to an antenna coil (211) formed in a SIM holder (201) or in an IC card holder (210).

4. The IC module (204) according to one of the preceding claims, wherein the antenna terminals (L1, L2) of the IC chip (203) are connected to the extra contact terminals CE1 (CE1) and CE2 (CE2) by wire bonding.

5. The IC module (204) according to one of the preceding claims, wherein the antenna terminals (L1, L2) of the IC chip (203) are connected to the extra contact terminals CE1 (CE1) and CE2 (CE2) via through holes.

6. The IC module (204) according to one of the preceding claims, wherein the IC chip (203) has a contact interface conforming to ISO 7816-2 and ISO 7816-3, a noncontact interface conforming to ISO 14443, and a USB contact interface.

7. The IC module (204) according to one of the preceding claims, wherein antenna-terminal plates (24,25) are connected said antenna-terminals (L1, L2) of the IC chip (203), and said antenna-terminal plates (24, 25) are adapted to be connected to antenna-terminals of an antenna coil.

8. An IC card (220) comprising an IC module (204) according to one of the preceding claims and a card holding the IC module (204).

9. A SIM (202), constituted of an IC card (220) according to claim 8.

10. The SIM (202) according to claim 9, wherein the extra contact terminals CE1 and CE2 (CE1, CE2) are those to be connected to an antenna coil (211) formed in a SIM holder.

11. The SIM (202) according to any one of claims 9 or 10, wherein one or some of a half-length photograph (207), a name (208) and a number (209) are printed on a surface of the SIM base (220b) opposite a surface of the SIM base (220b) on which the contact terminal plate (222) is mounted.

## Patentansprüche

1. IC-Modul (204), das umfasst:
- ein Substrat (204a);
- einen auf das Substrat (204a) montierten IC-Chip (203); und
- eine Kontaktanschlussplatte (222) mit einer Vielzahl von Kontaktanschlüssen (C1 - C8, CE1, CE2); und
wobei der IC-Chip (203) und die Kontaktanschlussplatte (222) auf das Substrat (204a) montiert sind; wobei
die Vielzahl von Kontaktanschlüssen Anschlüsse C1 - C8-(Cl - C8) umfasst, die dem ISO 7816-Standard entsprechen, und auf die Anschlüsse C1 - C2 (C1 - C8) in dem ISO 7816-Standard als C1 - C8 Bezug genommen wird; und
der IC-Anschluss zusätzliche Kontaktanschlüsse, die im folgenden mit CE1 und CE2 bezeichnet sind, (CE1, CE2) umfasst, die mit Antennenanschlüssen (L1, L2) des IC-Chips (203) verbunden sind, wobei die zusätzlichen Kontaktanschlüsse CE1, CE2 (CE1, CE2) der Kontaktanschlussplatte (222) geeignet sind, mit Antennenanschlüssen einer Antennenspule verbunden zu werden,
wobei das IC-Modul **dadurch gekennzeichnet ist, dass**
ein Paar U-förmiger Schaltungen (241, 242) ausgebildet ist, um den IC-Chip (203) auf einer Oberfläche des Substrats (204a) entgegengesetzt zu einer Oberfläche des Substrats (204a), auf der die Kontaktanschlussplatte (222) montiert ist, zu umschließen, wobei die zusätzlichen Kontaktanschlüsse CE1 und CE2 (CE1, CE2) jeweils mit den U-förmigen Schaltungen (241, 242) verbunden sind und die U-förmigen Schaltungen (241, 242) jeweils mit den Antennenanschlüssen (L1, L2) des IC-Chips (203) verbunden sind.

2. IC-Modul (204) nach Anspruch 1, wobei der zusätzliche Kontaktanschluss CE1 (CE1) zwischen dem Anschluss C1 (C1) und dem Anschluss C5 (C5) aus den acht Kontaktanschlüssen C1 - C8 (C1 - C8) angeordnet ist, und der zusätzliche Kontaktanschluss CE2 (CE2) zwischen den Anschlüssen C4 (C4) und C8 (C8) aus den acht Kontaktanschlüssen C1 - C8 (C1 - C8) angeordnet ist.

3. IC-Modul (204) nach einem der vorangehenden Ansprüche, wobei die zusätzlichen Kontaktanschlüsse CE1 (CE1) und CE2 (CE2) die sind, die mit einer Antennenspule (211) verbunden werden sollen, die in einer SIM-Halterung (201) oder in einer IC-Kartenhalterung (210) ausgebildet sind.

4. IC-Modul (204) nach einem der vorangehenden Ansprüche, wobei die Antennenanschlüsse (L1, L2) des IC-Chips (203) mit den zusätzlichen Kontaktanschlüssen CE1 (CE1) und CE2 (CE2) durch Drahtbonden verbunden sind.

5. IC-Modul (204) nach einem der vorangehenden Ansprüche, wobei die Antennenanschlüsse (L1, L2) des IC-Chips (203) mit den zusätzlichen Kontaktanschlüssen CE1 (CE1) und CE2 (CE2) über Durchgangslöcher verbunden sind.

6. IC-Modul (204) nach einem der vorangehenden Ansprüche, wobei der IC-Chip (203) eine ISO 7816-2 und ISO 7816-3 entsprechende Kontaktschnittstelle, eine ISO 14443 entsprechende Nichtkontaktschnittstelle und eine USB-Kontaktschnittstelle hat.

7. IC-Modul (204) nach einem der vorangehenden Ansprüche, wobei die Antennenanschlussplatten (24, 25) mit den Antennenanschlüssen (L1, L2) des IC-Chips (203) verbunden sind, und die Antennenanschlussplatten (24, 25) geeignet sind, mit den Antennenanschlüssen der Antennenspule verbunden zu werden.

8. IC-Karte (220), die ein IC-Modul (204) nach einem der vorangehenden Ansprüche und eine Karte, die das IC-Modul (201) aufnimmt, umfasst.

9. SIM (202), die aus einer IC-Karte (220) nach Anspruch 8 gebildet ist.

10. SIM (202) nach Anspruch 9, wobei die zusätzlichen Kontaktanschlüsse CE1 und CE2 (CE1, CE2) die sind, die mit einer Antennenspule (211) verbunden werden sollen, die in einer SIM-Halterung ausgebildet ist.

11. SIM (202) nach einem der Ansprüche 9 oder 10, wobei ein Passfoto (207) und/oder ein Name (208) und/oder eine Nummer (209) auf eine Oberfläche der SIM-Basis bzw. Grundlage (220b) gedruckt ist/sind, die entgegengesetzt zu einer Oberfläche der SIM-Basis (220b) ist, auf der die Kontaktanschlussplatte (222) montiert ist.

## Revendications

1. Module à circuit intégré (IC) (204), comprenant :
- un substrat (204a) ;
- une carte à circuit intégré (IC) (203) montée sur le substrat (204a) ; et
- une plaquette de bornes de contact (222) qui a une pluralité de bornes de contact (C1 - C8, CE1, CE2) ; et
sachant que ladite carte à circuit intégré (IC) (203) et ladite plaquette de bornes de contact (222) sont montées sur le substrat (204a) ; dans lequel la pluralité de bornes de contact inclut des bornes C1 - C8 (C1 - C8) conformément à la norme ISO 7816 et dans lequel lesdites bornes C1 - C8 (C1 - C8) sont en référence à C1 - C8 dans la norme ISO 7816 ; et ledit module à circuit intégré (IC) inclut des bornes de contact à part dénommées CE1 et CE2 (CE1, CE2) dans ce qui suit et connectées aux bornes d'antenne (L1, L2) de la carte à circuit intégré (IC) (203), sachant que lesdites bornes de contact à part CE1, CE2 (CE1, CE2) de la plaquette de bornes de contact (222) sont adaptées de manière à être connectées aux bornes d'antenne d'une bobine d'antenne,
ledit module à circuit intégré (IC) étant **caractérisé en ce que** :
une paire de circuits en forme de U (241, 242) est formée de manière à entourer la carte à circuit intégré (IC) (203) sur une surface du substrat (204a) opposée à une surface du substrat (204a) sur laquelle la plaquette de bornes de contact (222) est montée, dans lequel les bornes de contact à part CE1 et CE2 (CE1, CE2) sont connectées respectivement aux circuits en forme de U (241, 242), et dans lequel les circuits en forme de U (241, 242) sont connectés respectivement aux bornes d'antenne (L1, L2) de la carte à circuit intégré (IC) (203).

2. Module à circuit intégré (IC) (204) conformément à la revendication 1, dans lequel ladite borne de contact à part CE1 (CE1) est agencée entre ladite borne C1 (C1) et ladite borne C5 (C5) parmi lesdites huit bornes de contact C1 - C8 (C1 - C8), et dans lequel ladite borne de contact à part CE2 (CE2) est agencée entre lesdites bornes C4 (C4) et C8 (C8) parmi lesdites huit bornes de contact C1 - C8 (C1 - C8).

3. Module à circuit intégré (IC) (204) conformément à l'une des revendications précédentes, dans lequel les bornes de contact à part CE1 (CE1) et CE2 (CE2) sont celles qui doivent être connectées à une bobine d'antenne (211) formée dans un support de carte SIM (201) ou dans un support de carte à circuit intégré (IC) (210).

4. Module à circuit intégré (IC) (204) conformément à l'une des revendications précédentes, dans lequel les bornes d'antenne (L1, L2) de la carte à circuit intégré (IC) (203) sont connectées aux bornes de contact à part CE1 (CE1) et CE2 (CE2) par liaison des fils.

5. Module à circuit intégré (IC) (204) conformément à l'une des revendications précédentes, dans lequel les bornes d'antenne (L1, L2) de la carte à circuit intégré (IC) (203) sont connectées aux bornes de contact à part CE1 (CE2) et CE2 (CE2) par des trous de passage.

6. Module à circuit intégré (IC) (204) conformément à l'une des revendications précédentes, dans lequel la carte à circuit intégré (IC) (203) a une interface de contact qui est conforme aux normes ISO 7816-2 et ISO 7816-3, une interface de non contact qui est conforme à la norme ISO 14443, et une interface de contact USB.

7. Module à circuit intégré (IC) (204) conformément à l'une des revendications précédentes, dans lequel les plaquettes de borne d'antenne (24, 25) sont connectées aux dites bornes d'antenne (L1, L2) de la carte à circuit intégré (IC) (203), et dans lequel lesdites plaquettes de borne d'antenne (24, 25) sont adaptées de manière à être connectées aux bornes d'antenne de la bobine d'antenne.

8. Carte à circuit intégré (IC) (220) comprenant un module à circuit intégré (IC) (204) conformément à l'une des revendications précédentes et une carte qui porte le module à circuit intégré (IC) (204).

9. Carte SIM (202), constituée d'une carte à circuit intégré (IC) (220) conformément à la revendication 8.

10. Carte SIM (202) conformément à la revendication 9, dans laquelle les bornes de contact à part CE1 et CE2 (CE1, CE2) sont celles qui doivent être connectées à une bobine d'antenne (211) formée dans un support de carte SIM.

11. Carte SIM (202) conformément à l'une quelconque des revendications 9 ou 10, dans laquelle un composant ou quelques composants - parmi un portait en buste (207), un nom (208) et un numéro (209) - sont imprimés sur une surface de la base de carte SIM (220b) opposée à une surface de la base de carte SIM (220b) sur laquelle la plaquette de bornes de contact (222) est montée.
